# EUROPEAN PATENT APPLICATION

(11) **EP 4 734 711 A1**
(43) Date of publication of application: **29.04.2026**
(21) Application number: 25202232.2
(22) Date of filing: 15.09.2025
(51) Int. Cl.: H10F 39/00

(54) **IMAGE SENSOR HAVING NANO-PHOTONIC LENS ARRAY AND ELECTRONIC APPARATUS INCLUDING THE IMAGE SENSOR**

(30) Priority: 28.10.2024 KR 20240148972; 29.08.2025 KR 20250122565
(71) Applicant: Samsung Electronics Co., Ltd., Suwon-si, Gyeonggi-do 16677 (KR)
(72) Inventor: LEE, Sangyun, 16678 Suwon-si (KR); ROH, Sookyoung, 16678 Suwon-si (KR); CHO, Choonlae, 16678 Suwon-si (KR); AHN, Sungmo, 16678 Suwon-si (KR); LEE, Suyeon, 16678 Suwon-si (KR)
(74) Representative: Elkington and Fife LLP

(57) **Abstract**

Provided is an image sensor including a sensor substrate including a first pixel, a second pixel, a third pixel, and a fourth pixel, and a nano-photonic lens array including a first meta-region, a second meta-region, a third meta-region, and a fourth meta-region, each of the first to fourth meta-regions including a plurality of main nano-structures that are configured to color-separate incident light, a critical dimension of the main nano-structure being greater than or equal to 1/20 of the pixel pitch, and in the third meta-region, center points of the main nano-structures being only in a third section, the third section comprising a first portion defined along a rim of the third meta-region, a second portion extending in a first direction from a center of the third meta-region, and a third portion extending in a second direction crossing the first direction from the center of the third meta-region.

## Description

### FIELD OF THE INVENTION

Embodiments of the present disclosure relate to an image sensor including a nano-photonic lens array and an electronic apparatus including the image sensor.

### BACKGROUND OF THE INVENTION

Image sensors generally sense the color of incident light by using a color filter. However, a color filter may have low light utilization efficiency because the color filter absorbs light of colors other than the color of incident light. For example, in the case in which a red-green-blue (RGB) color filter is used, only 1/3 of incident light is transmitted therethrough and the other part of the incident light, that is, 2/3 of the incident light, is absorbed. Thus, light utilization efficiency is only about 33%. Thus, in a color display apparatus or a color image sensor, most light loss occurs in a color filter.

### SUMMARY OF THE INVENTION

One or more embodiments provide an image sensor including a nano-optical lens array and having improved optical efficiency, and an electronic apparatus including the image sensor.

One or more embodiments also provide an image sensor having an improved auto-focusing function and an electronic apparatus including the image sensor.

Additional aspects will be set forth in part in the description which follows and, in part, will be apparent from the description, or may be learned by practice of one or more embodiments.

According to an aspect of one or more embodiments, there is provided an image sensor including a sensor substrate including a plurality of unit pixel pattern, each of the plurality of unit pixel pattern including a first pixel, a second pixel, a third pixel, and a fourth pixel, and a nano-photonic lens array on the sensor substrate, the nano-photonic lens array including a plurality of unit meta-patterns, each of the plurality of unit meta-patterns being divided into a first meta-region, a second meta-region, a third meta-region, and a fourth meta-region, wherein the first meta-region, the second meta-region, the third meta-region, and the fourth meta-region include a plurality of main nano-structures, each of the plurality of main nano-structures having a critical dimension greater than or equal to 1/20 of the pixel pitch, wherein the plurality of main nano-structures is configured to form a plurality of light condensing areas in each of the first pixel, the second pixel, the third pixel, and the fourth pixel by condensing light incident on the nano-photonic lens array, wherein a center point of a main nano-structure of the plurality of main nano-structures in the third meta-region that is on an upper side of the third pixel and has the same area as the third pixel is in a third section, and wherein the third section includes a first portion defined along a rim of the third meta-region in the third meta-region, a second portion that extends in a first direction from a center of the third meta-region, and a third portion that extends in a second direction crossing the first direction from the center of the third meta-region.

Embodiments may propose sub-pixel light-converging nanostructures for improved autofocus capability of image sensors.

By way of example, proposals may relate to a method of improving an autofocus capability of image sensors by forming a metaphotonic nanostructure array capable of shaping a wavefront of light incident on an upper portion of an image sensor, with the method applied to recent ultra-fine image sensors in which a single color pixel is composed of multiple sub-pixels. This may be expanded to various image sensor fields that require color imaging and autofocus functions.

Proposed embodiments may relate to applications utilizing image sensors, such as mobile and electronic-system cameras. Other potential applications may include imaging, such as cameras, microscopes, and displays.

In some proposed embodiments, a nano optical structure that enables individual light collection for each sub-pixel is applied to an ultra-fine pixel image sensor in which a single pixel with the same color filter is composed of multiple sub-pixels. In particular, the structure may be applicable to fine pixel image sensors having CFAs of RGB Bayer, RYB, and CMY arrangements, in which a specific color appears twice (2x high sampling rate) as frequently as other colors within an individual CFA unit.

Embodiments may deal with form and arrangement of nano-optical structures on top of a sensor, which implement a light phase profile that enables individual fine pixel light collection essential for high-resolution image output and operation of an autofocus function in an ultra-fine pixel image sensor in which a color pixel is composed of multiple primary sub-pixels.

High-refractive-index transparent materials that may be used to implement the required light phase profile include TiO₂ or SiN. The nano-structure layer may be configured in one or two layers, and spaces between the nano-structures may be filled with air or oxide. Total heights of the nanostructures may be in the range of 0.5 to 1.5 µm, and thicknesses of interlayers located under the nanostructures for light collection are 0.25 to 0.5 times the size of the individual color pixel (single color pixel size pitch) of the sensor.

The nano-optical structures located above center color pixels of a CFA (i.e., pixels with higher sampling rates than other color pixels, such as Green pixels in RGB Bayer CFAs) may have 2-fold symmetry, and the nano-optical structures may be located above other color pixels (i.e., R/B pixels in RGB Bayer CFAs) have 4-fold symmetry.

When the size of a single color pixel of the image sensor is defined as pitch, a center point of a main post having a CD of 90 nm or more may be located within a central pitch/2 region above a short-wavelength band remaining color pixel (i.e., a B pixel in an RGB CFA), and within both an edge pitch/8 region and a central pitch/8-wide region of a long-wavelength band remaining color pixel (i.e., an R pixel in an RGB CFA).

In a design for maximizing the AF C/R of a center color pixel (i.e., a G pixel in an RGB CFA), a center point of the main post may be located within a region having a width of pitch/4 that converges toward a short-wavelength band remaining color pixel from above the center color pixel.

In a design for maximizing the AF C/R in all color pixels of a CFA, a center point of the main post may be located not only within a region having a width of pitch/4 that converges toward a short-wavelength band remaining color pixel from above a center color pixel, but also within a region having a width of pitch/4 that converges toward a long-wavelength band remaining color pixel

A width of the first portion, a width of the second portion in the second direction, and a width of the third portion in the first direction may be 1/8 of the pixel pitch.

The second portion and the third portion may cross each other at the center of the third meta-region.

The critical dimension of the main nano-structure may be greater than or equal to 90 nm.

A center point of a main nano-structure of the plurality of main nano-structures in the first meta-region that is on an upper side of the first pixel and has the same area as the first pixel may be in a first section, the first section extending in a first direction from a center of the first meta-region, and a width of the first section in a second direction being 1/4 of a pixel pitch.

A center of the first section may coincide with a center of the first meta-region in the second direction, and a width of the first section in the first direction is equal to a width of the first meta-region in the first direction.

A center point of a main nano-structure of the plurality of main nano-structures in the second meta-region that is on an upper side of the second pixel and has the same area as the second pixel may be in a second section, and the second section may have a square shape having a width in the first direction and a width in the second direction being 1/2 of the pixel pitch.

A center of the second section in the first direction and the second direction coincides with a center of the second meta-region in the first direction and the second direction.

A center point of the main nano-structure of the plurality of main nano-structures in the fourth meta-region that is on an upper side of the fourth pixel and has the same area as the fourth pixel may be in a fourth section, the fourth section extending in the second direction from a center of the fourth meta-region, and a width of the fourth section in the first direction being 1/4 of the pixel pitch.

The fourth section of the fourth meta-region may have a shape rotated by a 90-degree angle with respect to the first section of the first meta-region.

The first section of the first meta-region further may include a portion extending in the second direction from a center of the first meta-region, and a width of the first section, in the first direction, of the portion extending in the second direction may be 1/4 of the pixel pitch.

A center point of the main nano-structure of the plurality of main nano-structures in the fourth meta-region that is on an upper side of the fourth pixel and has the same area as the fourth pixel may be in a fourth section, the fourth section including a portion that extends in the second direction from a center of the fourth meta-region and a portion extending in the first direction from the center of the fourth meta-region, and a width of the fourth section, in the second direction, of the portion extending in the first direction and a width of the fourth section, in the first direction, of the portion extending in the second direction may be 1/4 of the pixel pitch.

Main nano-structures of the plurality of main nano-structures in the first meta-region and the fourth meta-region may be in a 2-fold symmetry, main nano-structures of the plurality of main nano-structures in the second meta-region and the third meta-region may be in a 4-fold symmetry, and an arrangement type of the main nano-structures in the fourth meta-region may be rotated by a 90-degree angle with respect to an arrangement type of the main nano-structures in the first meta-region.

The plurality of main nano-structures may be configured to color-separate incident light that is incident on the nano-photonic lens array and condense light of a first wavelength band onto the first pixel and the fourth pixel, light of a second wavelength band that is less than the first wavelength band onto the second pixel, and light of a third wavelength band that is greater than the first wavelength band onto the third pixel.

The first pixel, the second pixel, the third pixel, and the fourth pixel each may include a first sub-pixel, a second sub-pixel, a third sub-pixel, and a fourth sub-pixel that are grouped and disposed two-dimensionally, and the first sub-pixel, the second sub-pixel, the third sub-pixel, and the fourth sub-pixel may be configured to independently sense the incident light.

The plurality of main nano-structures may be configured to condense the light of the first wavelength band onto a center of the first sub-pixel, a center of the second sub-pixel, a center of the third sub-pixel, and a center of the fourth sub-pixel of the first pixel, and a center of the first sub-pixel, a center of the second sub-pixel, a center of the third sub-pixel, and a center of the fourth sub-pixel of the fourth pixel, condense the light of the second wavelength band onto a center of the first sub-pixel, a center of the second sub-pixel, a center of the third sub-pixel, and a center of the fourth sub-pixel being of the second pixel, and condense the light of the third wavelength band onto a center of the first sub-pixel, a center of the second sub-pixel, a center of the third sub-pixel, and a center of the fourth sub-pixel of the third pixel.

Each of the first sub-pixel, the second sub-pixel, the third sub-pixel, and the fourth sub-pixel may include a plurality of photosensitive cells that are in a group and configured to independently sense the incident light.

The first meta-region, the second meta-region, the third meta-region, and the fourth meta-region further may include a plurality of sub nano-structures each having a critical dimension less than 1/20 of the pixel pitch, and a center point in each of the plurality of sub nano-structures may be included in or outside of the first section.

The nano-photonic lens array may further include a first nano-structure layer and a second nano-structure layer on the first nano-structure layer, the first nano-structure layer and the second nano-structure layer may include the plurality of main nano-structures, and in at least one of the first nano-structure layer and the second nano-structure layer, center points of the plurality of main nano-structures may be in the third section.

According to another aspect of one or more embodiments, there is provided an electronic apparatus including a lens assembly configured to form an optical image of a subject, an image sensor configured to convert the optical image formed by the lens assembly into an electrical signal, and a processor configured to process a signal generated by the image sensor, wherein the image sensor includes a sensor substrate including a plurality of unit pixel pattern, each of the plurality of unit pixel pattern including a first pixel, a second pixel, a third pixel, and a fourth pixel, and a nano-photonic lens array on the sensor substrate, the nano-photonic lens array including a plurality of unit meta-patterns, each of the plurality of unit meta-patterns being divided into a first meta-region, a second meta-region, a third meta-region, and a fourth meta-region, wherein the first meta-region, the second meta-region, the third meta-region, and the fourth meta-region include a plurality of main nano-structures, each of the plurality of main nano-structures having a critical dimension greater than or equal to 1/20 of the pixel pitch, wherein the plurality of main nano-structures is configured to form a plurality of light condensing areas in each of the first pixel, the second pixel, the third pixel, and the fourth pixel by condensing light incident on the nano-photonic lens array, wherein a center point of a main nano-structure of the plurality of main nano-structures in the third meta-region that is on an upper side of the third pixel and has the same area as the third pixel is in a third section, wherein the third section includes a first portion defined along a rim of the third meta-region in the third meta-region, a second portion that extends in a first direction from a center of the third meta-region, and a third portion that extends in a second direction crossing the first direction from the center of the third meta-region.

### BRIEF DESCRIPTION OF DRAWINGS

The above and other aspects, features, and advantages of embodiments will be more apparent from the following description taken in conjunction with the accompanying drawings, in which:
FIG. 1 is a schematic block diagram of an image sensor according to one or more embodiments;
FIGS. 2A, 2B, and 2C are diagrams showing examples of various pixel arrangements in a pixel array of an image sensor;
FIGS. 3A and 3B are cross-sectional views schematically showing a structure of a pixel array in an image sensor according to one or more embodiments;
FIG. 4A is a plan view schematically showing a pixel arrangement of a sensor substrate in the pixel array of FIGS. 3A and 3B;
FIG. 4B is a plan view schematically showing another pixel arrangement of a sensor substrate in the pixel array of FIGS. 3A and 3B;
FIG. 5 is a plan view schematically showing a structure of a color filter layer in the pixel array of FIGS. 3A and 3B;
FIG. 6 is a diagram showing an example of a section in which main nano-structures are arranged in one unit meta-pattern of the nano-photonic lens array of FIGS. 3A and 3B;
FIG. 7 is a plan view showing an example of one unit meta-pattern in the nano-photonic lens array of FIG. 6;
FIGS. 8A, 8B, and 8C are diagrams respectively showing examples of an optical spot of blue light, an optical spot of green light, and an optical spot of red light formed on a sensor substrate by a nano-photonic lens array including the unit meta-pattern shown in FIG. 7;
FIG. 9 is a graph showing an example of a quantum efficiency QE of an image sensor including the nano-photonic lens array including the unit meta-pattern of FIG. 7;
FIG. 10 is a graph showing an example of an auto-focusing signal contrast ratio of an image sensor including the nano-photonic lens array including the unit meta-pattern of FIG. 7;
FIG. 11 is a diagram showing another example of a section in which main nano-structures are arranged in one unit meta-pattern of a nano-photonic lens array;
FIG. 12 is a plan view showing an example structure of one unit meta-pattern of the nano-photonic lens array of FIG. 11;
FIG. 13 is a graph showing an example of a QE of an image sensor including the nano-photonic lens array including the unit meta-pattern of FIG. 12;
FIG. 14 is a graph showing an example of an auto-focusing signal contrast ratio of an image sensor including the nano-photonic lens array including the unit meta-pattern of FIG. 12;
FIG. 15 is a plan view showing another example structure of one unit meta-pattern of the nano-photonic lens array of FIG. 6;
FIG. 16 is a plan view showing another example structure of one unit meta-pattern of the nano-photonic lens array of FIG. 11;
FIGS. 17A and 17B are cross-sectional views schematically showing a structure of a pixel array in an image sensor according to one or more other embodiments;
FIG. 18A is a plan view showing an example structure of a first nano-structure layer in one unit meta-pattern of the nano-photonic lens array of FIG. 6, and FIG. 18B is a plan view showing an example structure of a second nano-structure layer in one unit meta-pattern of the nano-photonic lens array of FIG. 6;
FIG. 19A is a plan view showing an example structure of a first nano-structure layer in one unit meta-pattern of the nano-photonic lens array of FIG. 11, and FIG. 19B is a plan view showing an example structure of a second nano-structure layer in one unit meta-pattern of the nano-photonic lens array of FIG. 11;
FIG. 20 is a cross-sectional view schematically showing a cross-sectional structure in a peripheral portion of a pixel array according to one or more embodiments, and FIG. 21 is a diagram showing example of relative positions of a sensor substrate, a color filter layer, and a nano-photonic lens array in a peripheral portion of the pixel array according to one or more embodiments;
FIG. 22 is a block diagram of an electronic apparatus including an image sensor according to one or more embodiments;
FIG. 23 is a block diagram of a camera module in FIG. 22;
FIG. 24 is a block diagram of an electronic device including a multi-camera module; and
FIG. 25 is a detailed block diagram of the multi-camera module in the electronic device of FIG. 24.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, an image sensor including a nano-photonic lens array and an electronic apparatus including the image sensor will be described in detail with reference to accompanying drawings. Embodiments described herein are capable of various modifications and may be embodied in many different forms. In the drawings, like reference numerals denote like components, and sizes of components in the drawings may be exaggerated for convenience of explanation.

When a layer, a film, a region, or a panel is referred to as being "on/under" another element, it may be directly on/under/at left/right sides of the other layer or substrate, or intervening layers may also be present.

It will be understood that although the terms "first," "second," etc. may be used herein to describe various components, these components should not be limited by these terms. These components are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprising" another component, the portion may not exclude another component but may further comprise another component unless the context states otherwise.

In addition, the terms such as "... unit", "module", etc. provided herein indicates a unit performing a function or an operation, and may be realized by hardware, software, or a combination of hardware and software.

The use of the terms of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe technical detail, and the scope of rights is not limited by these terms unless the context is limited by the claims.

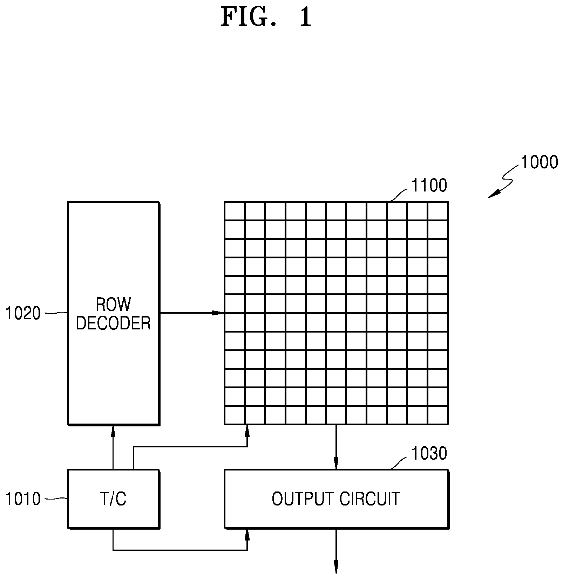

FIG. 1 is a schematic block diagram of an image sensor 1000 according to one or more embodiments. Referring to FIG. 1, the image sensor 1000 may include a pixel array 1100, a timing controller (T/C) 1010, a row decoder 1020, and an output circuit 1030. The image sensor 1000 may be a charge-coupled device (CCD) image sensor or a complementary metal oxide semiconductor (CMOS) image sensor.

The pixel array 1100 includes pixels that are two-dimensionally disposed in a plurality of rows and columns. The row decoder 1020 selects one of the rows in the pixel array 1100, in response to a row address signal output from the T/C 1010. The output circuit 1030 outputs a photosensitive signal from a plurality of pixels disposed in the selected row in a column unit. To this end, the output circuit 1030 may include a column decoder and an analog-to-digital converter (ADC). For example, the output circuit 1030 may include a plurality of ADCs that are respectively disposed in columns between the column decoder and the pixel array 1100, or one ADC disposed at an output end of the column decoder. The T/C 1010, the row decoder 1020, and the output circuit 1030 may be implemented as one chip or in separate chips. A processor for processing an image signal output from the output circuit 1030 may be implemented as one chip with the T/C 1010, the row decoder 1020, and the output circuit 1030.

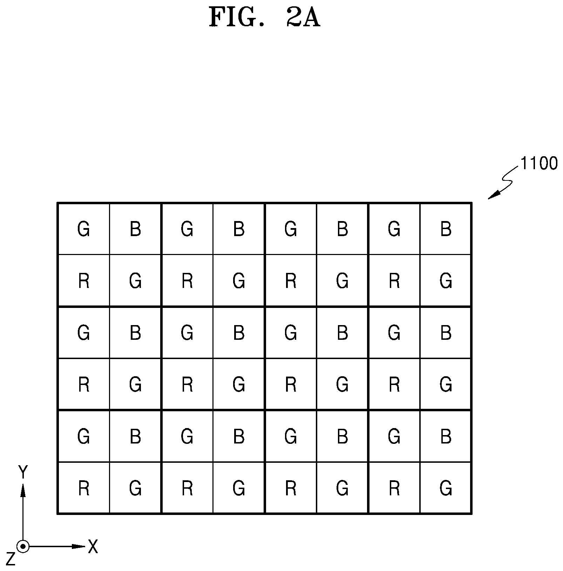

The pixel array 1100 may include a plurality of pixels that sense light of different wavelengths. The pixel arrangement may be implemented in various ways. For example, FIGS. 2A to 2C show various pixel arrangements in the pixel array 1100 of the image sensor 1000.

FIG. 2A shows an arrangement of a Bayer pattern that is generally used in the image sensor 1000. Referring to FIG. 2A, one unit pixel pattern includes four quadrant regions, and first through fourth quadrants may be the blue pixel B, the green pixel G, the red pixel R, and the green pixel G, respectively. The unit pixel patterns are repeatedly two-dimensionally arranged in a first direction (X-direction) and a second direction (Y-direction) perpendicularly crossing the first direction. For example, two green pixels G are disposed in one diagonal direction and one blue pixel B and one red pixel R are disposed in another diagonal direction in a unit pixel pattern of a 2×2 array. In the entire arrangement of pixels, a first row in which a plurality of green pixels G and a plurality of blue pixels B are alternately disposed in the first direction and a second row in which a plurality of red pixels R and a plurality of green pixels G are alternately disposed in the first direction are repeatedly disposed in a second direction.

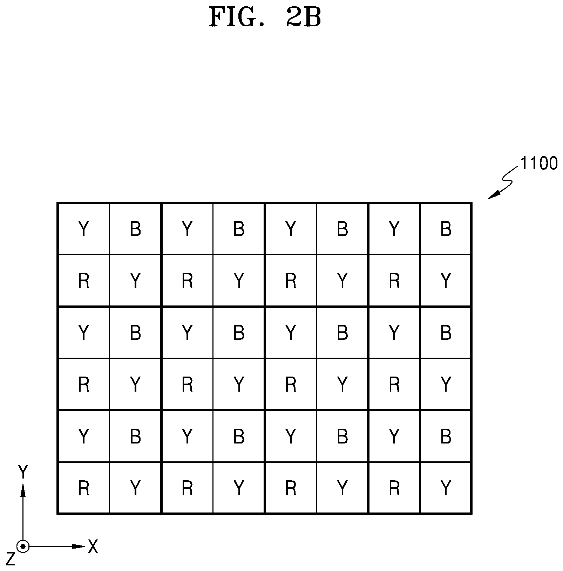

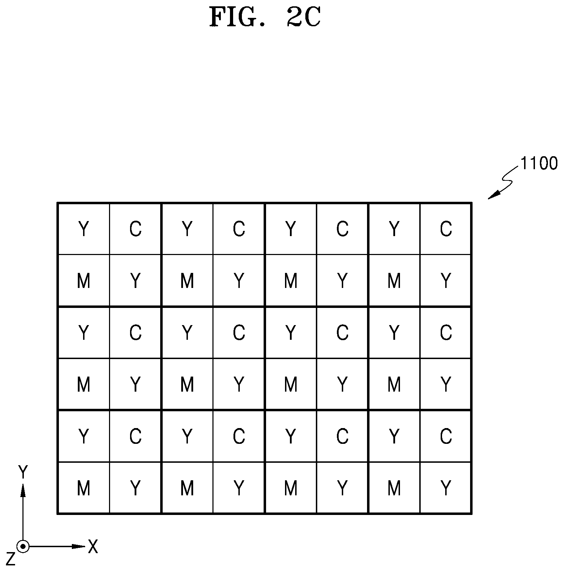

The pixel array 1100 may have various arrangement patterns, rather than the Bayer pattern. For example, referring to FIG. 2B, a red-yellow-blue (RYB) arrangement in which a yellow pixel Y is used instead of a green pixel G in the Bayer pattern may be used. Also, referring to FIG. 2C, a cyan-magenta-yellow (CMY) arrangement in which a cyan pixel C, a magenta pixel M, and two yellow pixels Y form one unit pixel pattern may be used. In the arrangements shown in FIGS. 2A to 2C, the number of certain color channels may be twice as those of the other color channels in one unit pixel pattern. For example, in the RGB Bayer pattern shown in FIG. 2A, green channels are twice more than red channels or blue channels. In the RYB arrangement shown in FIG. 2B, yellow channels may be twice more than the red channels or blue channels. In the CMY arrangement shown in FIG. 2C, yellow channels are twice of the cyan channels or magenta channels.

Hereinafter, an example in which the pixel array 1100 of the image sensor 1000 has the Bayer pattern structure shown in FIG. 2A is described, but operating principles may be identically applied to other types of pixel arrangements shown in FIG. 2B or 2C.

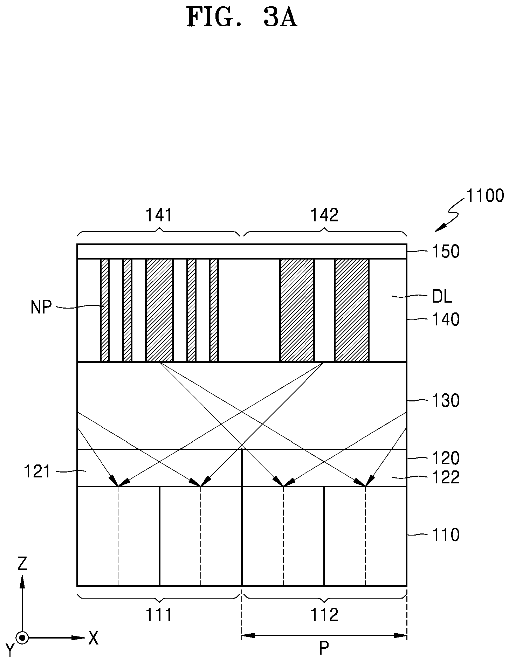

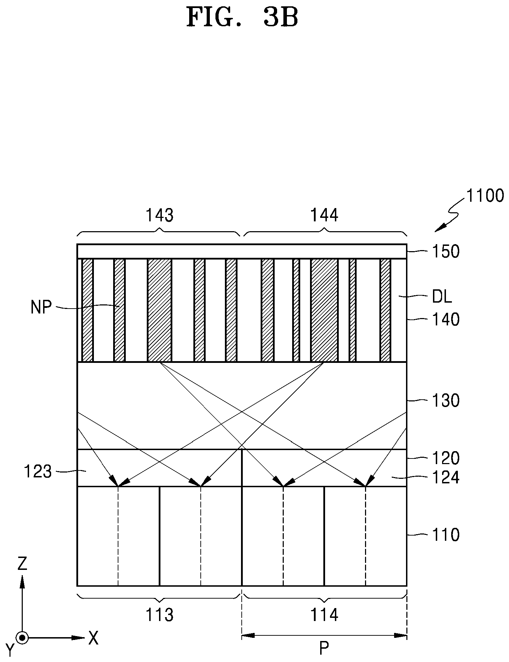

FIGS. 3A and 3B are cross-sectional views schematically showing a structure of the pixel array 1100 in the image sensor 1000 according to one or more embodiments. FIG. 3A shows a cross-section of the pixel array 1100 taken along the first direction (X-direction), and FIG. 3B shows a cross-section of the pixel array 1100, taken along the first direction (X-direction) at a location different from that of FIG. 3A in the second direction (Y-direction).

Referring to FIGS. 3A and 3B, the pixel array 1100 may include a sensor substrate 110, a color filter layer 120 provided on the sensor substrate 110, a spacer layer 130 that is transparent and provided on the color filter layer 120, a nano-photonic lens array 140 provided on the spacer layer 130, and an anti-reflection layer 150 provided on the nano-photonic lens array 140. For example, the color filter layer 120 may be provided between the sensor substrate 110 and the spacer layer 130, the spacer layer 130 may be provided between the color filter layer 120 and the nano-photonic lens array 140, and the nano-photonic lens array 140 may be provided between the spacer layer 130 and the anti-reflection layer 150.

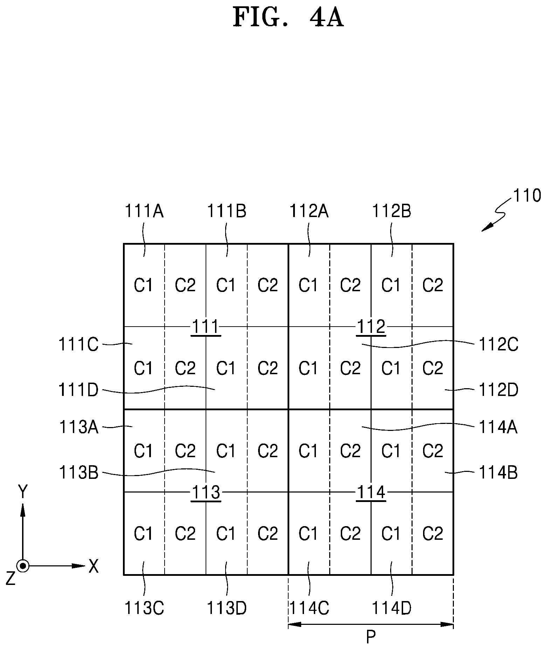

FIG. 4A is a plan view schematically showing a pixel arrangement of the sensor substrate 110 in the pixel array 1100 of FIGS. 3A and 3B. Referring to FIG. 4A, the sensor substrate 110 may include a first pixel 111, a second pixel 112, a third pixel 113, and a fourth pixel 114 that convert incident light into electrical signals and generate an image signal. The first pixel 111, the second pixel 112, the third pixel 113, and the fourth pixel 114 may form one unit pixel pattern.

Although FIG. 4A only shows one unit pixel pattern for convenience of description, a plurality of unit pixel patterns each including the first pixel 111, the second pixel 112, the third pixel 113, and the fourth pixel 114 may be periodically and repeatedly arranged in a first direction (X-direction) and a second direction (Y-direction) in a two-dimensional arrangement. For example, a plurality of first pixels 111 and a plurality of second pixels 112 may be alternately disposed in the first direction, and a plurality of third pixels 113 and a plurality of fourth pixels 114 may be alternately disposed in the first direction on a cross-section located differently in the second direction that perpendicularly crosses the first direction. Also, the plurality of first pixels 111 and the plurality of fourth pixels 114 may be alternately arranged in a first diagonal direction and the plurality of second pixels 112 and the plurality of third pixels 113 may be alternately arranged in a second diagonal direction crossing the first diagonal direction.

In an example, the first and fourth pixels 111 and 114 may be green pixels sensing green light, the second pixel 112 may be a blue pixel sensing blue light, and the third pixel 113 may be a red pixel sensing red light. In another example, the first and fourth pixels 111 and 114 may be yellow pixels sensing yellow light, the second pixel 112 may be a blue pixel sensing blue light, and the third pixel 113 may be a red pixel sensing red light. In another example, the first and fourth pixels 111 and 114 may be yellow pixels sensing yellow light, the second pixel 112 may be a cyan pixel sensing cyan light, and the third pixel 113 may be a magenta pixel sensing magenta light. For example, when the image sensor 1000 generates images by using the light of a first wavelength band that is an intermediate wavelength band, a second wavelength band that is a short wavelength band less than the intermediate wavelength band, and a third wavelength band that is a long wavelength band greater than the intermediate wavelength band, the first pixel 111 and the fourth pixel 114 may sense the light of the first wavelength band, the second pixel 112 may sense the light of the second wavelength band that is shorter than the first wavelength band, and the third pixel 113 may sense the light of the third wavelength band that is longer than the first wavelength band.

Each of the first to fourth pixels 111, 112, 113, and 114 may include a plurality of sub-pixels that independently sense incident light. For example, the first pixel 111 may include a first sub-pixel 111A, a second sub-pixel 111B, a third sub-pixel 111C, and a fourth sub-pixel 111D that are grouped in a 2x2 array and two-dimensionally arranged. Also, the second pixel 112 may include a first sub-pixel 112A, a second sub-pixel 112B, a third sub-pixel 112C, and a fourth sub-pixel 112D that are grouped in a 2x2 array and two-dimensionally arranged, the third pixel 113 may include a first sub-pixel 113A, a second sub-pixel 113B, a third sub-pixel 113C, and a fourth sub-pixel 113D that are grouped in a 2x2 array and two-dimensionally arranged, and the fourth pixel 114 may include a first sub-pixel 114A, a second sub-pixel 114B, a third sub-pixel 114C, and a fourth sub-pixel 114D that are grouped in a 2x2 array and two-dimensionally arranged.

A pixel pitch P of each of the first to fourth pixels 111, 112, 113, and 114 in the first or second direction may be greater than or equal to about 1 µm, for example, about 1 µm to about 1.5 µm. Here, the pixel pitch P may be defined as a width of each of the first to fourth pixels 111, 112, 113, and 114 in the first or second direction. A sub-pixel pitch may be half of the pixel pitch P. For example, the sub-pixel pitch may be less than about 1 µm or less than or equal to about 0.7 µm. The sub-pixel pitch may be defined as a width of each sub-pixel along the first direction or the second direction. In order to address such issues as light intensity reduction and resolution degradation due to ultra-miniaturization of the pixel sizes, sub-pixels of the same color are gathered to act as one pixel in a relatively low illuminance environment lacking light intensity, and the sub-pixels act as individual pixels to generate a high-resolution image in a high illuminance environment with sufficient light intensity.

For example, in the relatively low illuminance environment, the first pixel 111 outputs one first color image signal by summing outputs from the first sub-pixel 111A, the second sub-pixel 111B, the third sub-pixel 111C, and the fourth sub-pixel 111D, the second pixel 112 outputs one second color image signal by summing outputs from the first sub-pixel 112A, the second sub-pixel 112B, the third sub-pixel 112C, and the fourth sub-pixel 112D, the third pixel 113 outputs one third color image signal by summing outputs from the first sub-pixel 113A, the second sub-pixel 113B, the third sub-pixel 113C, and the fourth sub-pixel 113D, and the fourth pixel 114 outputs one fourth color image signal by summing outputs from the first sub-pixel 114A, the second sub-pixel 114B, the third sub-pixel 114C, and the fourth sub-pixel 114D.

In the relatively high illuminance environment, the first sub-pixel 111A, the second sub-pixel 111B, the third sub-pixel 111C, and the fourth sub-pixel 111D may individually output first color image signals. Therefore, the first pixel 111 may output four first color image signals having different spatial information. Similarly, the second pixel 112 may output four second color image signals having different spatial information respectively from the first sub-pixel 112A, the second sub-pixel 112B, the third sub-pixel 112C, and the fourth sub-pixel 112D, the third pixel 113 may output four third color image signals having different spatial information respectively from the first sub-pixel 113A, the second sub-pixel 113B, the third sub-pixel 113C, and the fourth sub-pixel 113D, and the fourth pixel 114 may output four first color image signals having different spatial information respectively from the first sub-pixel 114A, the second sub-pixel 114B, the third sub-pixel 114C, and the fourth sub-pixel 114D.

Also, in order to implement an auto-focusing function in a phase detection manner, each of the sub-pixels may include a plurality of photosensitive cells independently sensing incident light. For example, the first sub-pixel 111A, the second sub-pixel 111B, the third sub-pixel 111C, and the fourth sub-pixel 111D of the first pixel 111 may each include a first photosensitive cell C1 and a second photosensitive cell C2 that are adjacent to each other. Similarly, the first sub-pixel 112A, the second sub-pixel 112B, the third sub-pixel 112C, and the fourth sub-pixel 112D of the second pixel 112, the first sub-pixel 113A, the second sub-pixel 113B, the third sub-pixel 113C, and the fourth sub-pixel 113D of the third pixel 113, and the first sub-pixel 114A, the second sub-pixel 114B, the third sub-pixel 114C, and the fourth sub-pixel 114D of the fourth pixel 114 may each include the first photosensitive cell C1 and the second photosensitive cell C2 that are adjacent to each other.

FIG. 4A shows that the first photosensitive cell C1 and the second photosensitive cell C2 in each sub-pixel are divided in the second direction and adjacent to each other in the first direction, but the first photosensitive cell C1 and the second photosensitive cell C2 may be divided in the first direction and adjacent to each other in the second direction. According to the embodiment, the auto-focusing function may be implemented by using a difference or a ratio between an output signal from the first photosensitive cell C1 and an output signal from the second photosensitive cell C2 in each sub-pixel. The image signal from each sub-pixel may be obtained by summing the output from the first photosensitive cell C1 and the output from the second photosensitive cell C2 in each sub-pixel.

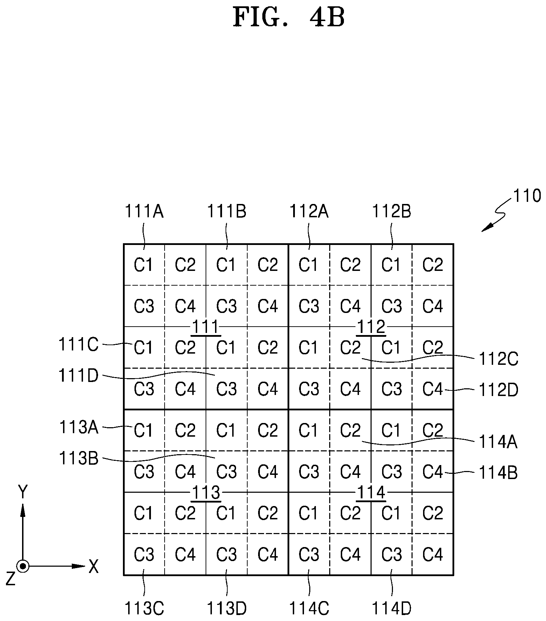

FIG. 4B is a plan view schematically showing another pixel arrangement of the sensor substrate 110 in the pixel array 1100 of FIGS. 3A and 3B. FIG. 4A shows that each sub-pixel includes two photosensitive cells, but as shown in FIG. 4B, each of the sub-pixels may include four photosensitive cells that are grouped in a 2x2 array and two-dimensionally arranged. For example, the first sub-pixel 111A, the second sub-pixel 111B, the third sub-pixel 111C, and the fourth sub-pixel 111D of the first pixel 111, the first sub-pixel 112A, the second sub-pixel 112B, the third sub-pixel 112C, and the fourth sub-pixel 112D of the second pixel 112, the first sub-pixel 113A, the second sub-pixel 113B, the third sub-pixel 113C, and the fourth sub-pixel 113D of the third pixel 113, and the first sub-pixel 114A, the second sub-pixel 114B, the third sub-pixel 114C, and the fourth sub-pixel 114D of the fourth pixel 114 may each include the first photosensitive cell C1, the second photosensitive cell C2, the third photosensitive cell C3, and the fourth photosensitive cell C4 that are grouped in a 2x2 array and two-dimensionally arranged.

Then, the auto-focusing signal may be obtained from the difference between the output signals from the adjacent photosensitive cells in various ways. For example, in each of the sub-pixels, an autofocusing signal in the first direction may be generated from a difference between output signals from the first photosensitive cell C1 and the second photosensitive cell C2, a difference between output signals from the third photosensitive cell C3 and the fourth photosensitive cell C4, or a difference between the sum of the output signals from the first photosensitive cell C1 and the third photosensitive cell C3 and the sum of the output signals from the second photosensitive cell C2 and the fourth photosensitive cell C4. Also, an auto-focusing signal in the second direction may be generated from a difference between output signals from the first photosensitive cell C1 and the third photosensitive cell C3, a difference between output signals from the second photosensitive cell C2 and the fourth photosensitive cell C4, or a difference between the sum of the output signals from the first photosensitive cell C1 and the second photosensitive cell C2 and the sum of the output signals from the third photosensitive cell C3 and the fourth photosensitive cell C4. The image signal from each sub-pixel may be obtained by summing the output from the first photosensitive cell C1, the outputs from the second photosensitive cell C2 and the third photosensitive cell C3, and the output from the fourth photosensitive cell C4 in each sub-pixel.

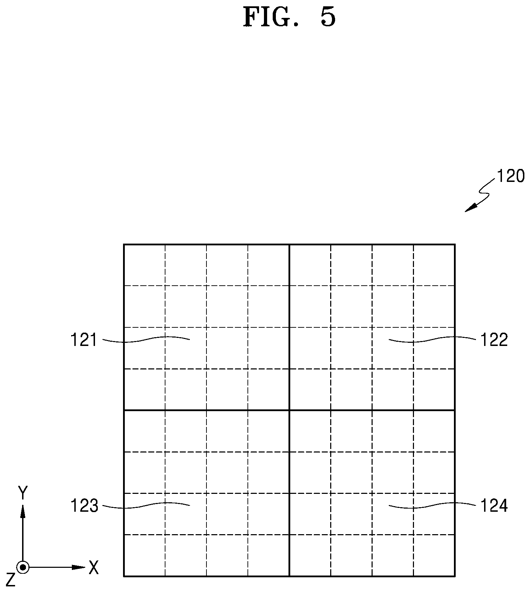

FIG. 5 is a plan view schematically showing a configuration of the color filter layer 120 in the pixel array 1100 shown in FIGS. 3A and 3B. Referring to FIG. 5, the color filter layer 120 may include a plurality of color filters that are disposed between the sensor substrate 110 and the nano-photonic lens array 140 so as to transmit light of a certain wavelength band and absorb light of another wavelength band other than the certain wavelength band. For example, the color filter layer 120 may include a first color filter 121 and a fourth color filter 124 that transmit light of a first wavelength band and absorb light of another wavelength band other than the first wavelength band, a second color filter 122 that transmits light of a second wavelength band that is different from the first wavelength band and absorbs light of another wavelength band other than the second wavelength band, and a third color filter 123 that transmits light of a third wavelength band that is different from the first and second wavelength bands and absorbs light of another wavelength band other than the third wavelength band.

The first color filter 121, the second color filter 122, the third color filter 123, and the fourth color filter 124 may form one unit color filter pattern. In the color filter layer 120, a plurality of unit color filter patterns each including the first color filter 121, the second color filter 122, the third color filter 123, and the fourth color filter 124 are periodically and repeatedly arranged in a two-dimensional array in the first direction (X-direction) and the second direction (Y-direction). For example, a plurality of first color filters 121 and a plurality of second color filter 122 may be alternately arranged in the first direction, and a plurality of third color filters 123 and a plurality of fourth color filters 124 may be alternately arranged in the first direction on a cross-section of a different position in the second direction that perpendicularly crosses the first direction. Also, a plurality of first color filters 121 and a plurality of fourth color filters 124 may be alternately arranged in the first diagonal direction, and a plurality of second color filters 122 and a plurality of third color filters 123 may be alternately arranged in the second diagonal direction crossing the first diagonal direction.

The first color filter 121 may be disposed to face the first pixel 111 in a third direction (Z-direction) that crosses perpendicularly to the first and second directions, the second color filter 122 may be disposed to face the second pixel 112 in the third direction, the third color filter 123 may be disposed to face the third pixel 113 in the third direction, and the fourth color filter 124 may be disposed to face the fourth pixel 114 in the third direction. Accordingly, the first pixel 111 may sense the light of the first wavelength band having passed through the first color filter 121 corresponding thereto. The second pixel 112 senses the light of the second wavelength band having passed through the second color filter 122 corresponding thereto, and the third pixel 113 senses the light of the third wavelength band having passed through the third color filter 123 corresponding thereto. The fourth pixel 114 may sense the light of the first wavelength band having passed through the fourth color filter 124 corresponding thereto.

In an example, the first color filter 121 and the fourth color filter 124 may be green color filters transmitting the green light, the second color filter 122 may be a blue color filter transmitting the blue light, and the third color filter 123 may be a red color filter transmitting the red light. In another example, the first color filter 121 and the fourth color filter 124 may be yellow color filters transmitting yellow light, the second color filter 122 may be a blue color filter, and the third color filter 123 may be a red color filter. In another example, the first color filter 121 and the fourth color filter 124 may be yellow color filters, the second color filter 122 may be a cyan color filter transmitting cyan light, and the third color filter 123 may be a magenta color filter transmitting magenta light.

The first to fourth color filters 121, 122, 123, and 124 may be disposed to face all the sub-pixels and the photosensitive cells in the first to fourth pixels 111, 112, 113, and 114 respectively corresponding thereto in the third direction. For example, the first color filter 121 may be provided on and cover all the sub-pixels and the photosensitive cells in the first pixel 111 corresponding thereto, the second color filter 122 may be provided on and cover all the sub-pixels and the photosensitive cells in the second pixel 112 corresponding thereto, the third color filter 123 may be provided on and cover all the sub-pixels and the photosensitive cells in the third pixel 113 corresponding thereto, and the fourth color filter 124 may be provided on and cover all the sub-pixels and photosensitive cells in the fourth pixel 114 corresponding thereto. In FIG. 5, the dashed lines indicate, as an example, boundaries of the sub-pixels and the photosensitive cells in the pixel corresponding to each color filter.

The first to fourth color filters 121, 122, 123, and 124 in the color filter layer 120 may be formed of, for example, an organic polymer material. For example, the first to fourth color filters 121, 122, 123, and 124 may include a coloring agent, binder resin, polymer photoresist, etc. For example, the first and fourth color filters 121 and 124 may be organic color filters including green organic dye or a green organic pigment as a coloring agent, the second color filter 122 may be an organic color filter including a blue organic dye or a blue organic pigment as a coloring agent, and the third color filter 123 may be an organic color filter including a red organic dye or a red organic pigment as a coloring agent. For example, the color filter layer 120 may further include a black matrix disposed at boundaries between the first to fourth color filters 121, 122, 123, and 124. The black matrix may include, for example, carbon black.

Referring back to FIGS. 3A and 3B, the spacer layer 130 arranged between the color filter layer 120 and the nano-photonic lens array 140 may provide a flat surface for forming the nano-photonic lens array 140 thereon. The spacer layer 130 may include an organic polymer material that may be stacked on the color filter layer 120 that is formed of an organic material and may more easily form a flat surface. The organic polymer material forming the spacer layer 130 may be transparent with respect to visible light. For example, the spacer layer 130 may include at least one organic polymer material from an epoxy resin, polyimide, polycarbonate, polyacrylate, and polymethyl methacrylate (PMMA). The spacer layer 130 may be formed on the color filter layer 120 by, for example, a spin coating method, and may have a flat upper surface through a thermal treatment. Also, the spacer layer 130 may provide a distance that is sufficient enough to color-separate the light by using the nano-photonic lens array 140. For example, a thickness of the spacer layer 130 may range from about 0.25 times to about 0.5 times of the pixel pitch P.

The nano-photonic lens array 140 may be arranged on the spacer layer 130. FIGS. 3A and 3B show that the nano-photonic lens array 140 is directly disposed on the spacer layer 130, but an inorganic protective layer for preventing damage to the spacer layer 130 that is formed of an organic polymer material during the process of forming the nano-photonic lens array 140 may be disposed on the spacer layer 130, and then, the nano-photonic lens array 140 may be disposed on the inorganic protective layer. Also, in order to protect the spacer layer 130 while forming the nano-photonic lens array 140, an etch stop layer may be further arranged between the spacer layer 130 and the nano-photonic lens array 140.

The nano-photonic lens array 140 may be configured to color-separate incident light. For example, the nano-photonic lens array 140 may separate the light of first wavelength band (e.g., green light or yellow light), the light of second wavelength band (e.g., blue light or cyan light), and the light of third wavelength band (e.g., red light or magenta light) from the incident light and allow the separated light to proceed in different passages. Also, the nano-photonic lens array 140 may be configured to act as a lens condensing light of the first wavelength band, light of the second wavelength band, and light of the third wavelength band that are color-separated onto sub-pixels. For example, the nano-photonic lens array 140 may be configured to form a plurality of light condensing areas in each of the first pixel 111, the second pixel 112, the third pixel 113, and the fourth pixel 114 by condensing the incident light. In particular, the nano-photonic lens array 140 may condense the light of the first wavelength band, in the incident light, onto the first sub-pixel 111A, the second sub-pixel 111B, the third sub-pixel 111C, and the fourth sub-pixel 111D of the first pixel 111, and the first sub-pixel 114A, the second sub-pixel 114B, the third sub-pixel 114C, and the fourth sub-pixel 114D of the fourth pixel 114, condense the light of the second wavelength band onto the first sub-pixel 112A, the second sub-pixel 112B, the third sub-pixel 112C, and the fourth sub-pixel 112D of the second pixel 112, and condense the light of the third wavelength band onto the first sub-pixel 113A, the second sub-pixel 113B, the third sub-pixel 113C, and the fourth sub-pixel 113D of the third pixel 113.

To this end, the nano-photonic lens array 140 may include a first meta-region 141 corresponding to the first pixel 111, a second meta-region 142 corresponding to the second pixel 112, a third meta-region 143 corresponding to the third pixel 113, and a fourth meta-region 144 corresponding to the fourth pixel 114. The first meta-region 141, the second meta-region 142, the third meta-region 143, and the fourth meta-region 144 may each include a plurality of nano-structures NP arranged according to a certain rule. Also, the nano-photonic lens array 140 may further include a dielectric layer DL filled among the plurality of nano-structures NP. In order for the nano-photonic lens array 140 to perform the above functions, the plurality of nano-structures NP of the nano-photonic lens array 140 may be variously formed.

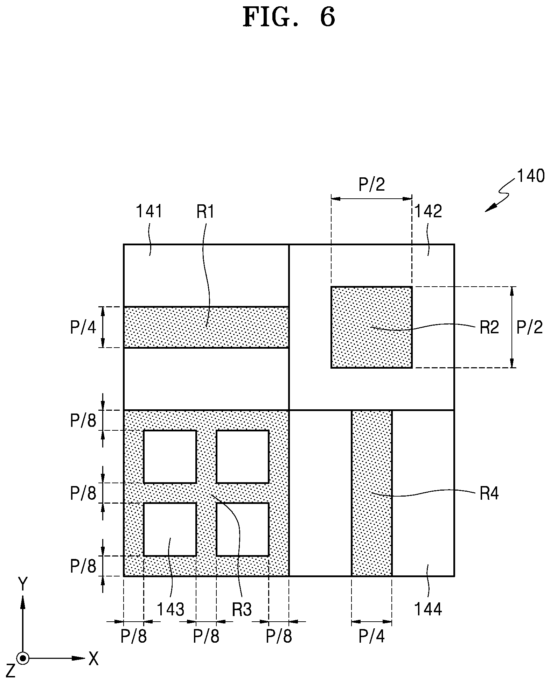

FIG. 6 is a diagram showing an example of a section in which main nano-structures are arranged in one unit meta-pattern of the nano-photonic lens array 140 of FIGS. 3A and 3B. Referring to FIG. 6, the unit meta-pattern of the nano-photonic lens array 140 may include a first meta-region 141 corresponding to and facing the first pixel 111, a second meta-region 142 corresponding to and facing the second pixel 112, a third meta-region 143 corresponding to and facing the third pixel 113, and a fourth meta-region 144 corresponding to and facing the fourth pixel 114. For example, the first meta-region 141 may be arranged to face the first pixel 111 in the third direction, the second meta-region 142 may be arranged to face the second pixel 112 in the third direction, the third meta-region 143 may be arranged to face the third pixel 113 in the third direction, and the fourth meta-region 144 may be arranged to face the fourth pixel 114 in the third direction. In one unit meta-pattern, the first meta-region 141 and the fourth meta-region 144 are arranged in the first diagonal direction, and the second meta-region 142 and the third meta-region 143 may be arranged in the second diagonal direction. The first meta-region 141 provided on an upper side of the first pixel 111 may have the same area as the first pixel 111, the second meta-region 142 provided on an upper side of the second pixel 112 may have the same area as the second pixel 112, the third meta-region 143 provided on an upper side of the third pixel 113 may have the same area as the third pixel 113, and the fourth meta-region 144 provided on an upper side of the fourth pixel 114 may have the same area as the fourth pixel 114.

FIG. 6 shows one unit meta-pattern as an example, but a plurality of first meta-regions 141 and a plurality of second meta-regions 142 may be alternately arranged in the first direction, and a plurality of third meta-regions 143 and a plurality of fourth meta-regions 144 may be alternately arranged in the first direction on a cross-section at a position that is different in the second direction perpendicularly crossing the first direction. For example, the nano-photonic lens array 140 may include a plurality of unit meta-patterns that are periodically and two-dimensionally arranged in the first and second directions. Each of the plurality of unit meta-patterns may be divided into the first meta-region 141, the second meta-region 142, the third meta-region 143, and the fourth meta-region 144.

The nano-photonic lens array 140 may include a plurality of nano-structures that are respectively arranged in the first to fourth meta-regions 141, 142, 143, and 144 so as to color-separate the incident light and condense the separated light. The plurality of nano-structures may be arranged in the first to fourth meta-regions 141, 142, 143, and 144 according to certain rules. In order to improve the auto-focusing function by increasing the auto-focusing signal ratio, the center of a main nano-structure of a certain size or greater from among the plurality of nano-structures may be located only in a certain section from among the first meta-region 141, the second meta-region 142, the third meta-region 143, and the fourth meta-region 144. The main nano-structure denotes a nano-structure of which a critical dimension (CD), for example, a cross-sectional diameter or a cross-sectional width, is a certain reference value or greater. For example, from among the plurality of nano-structures, the nano-structure having the CD of greater than or equal to 90 nm may be defined as a main nano-structure. As another example, the nano-structure having the CD greater than or equal to 1/20 of the pixel pitch P or greater than or equal to 1/10 of the sub-pixel pitch may be defined as the main nano-structure.

For example, in the first meta-region 141, a first section R1 in which the center of the main nano-structure is located may have a rectangular shape extending along the first direction from a center of the first meta-region 141 in the second direction. For example, the first section R1 may be a rectangle in which a width in the first direction is greater than a width in the second direction. The center of the first section R1 in the second direction may coincide with the center of the first meta-region 141 in the second direction. A width of the first section R1 in the first direction is equal to a width of the first meta-region 141 in the first direction, and a width in the second direction of the first section R1 may be 1/4 of the pixel pitch P. Therefore, an end portion of the first section R1 in the first direction may come into contact with a boundary between the first meta-region 141 and the second meta-region 142. For example, in the first meta-region 141 facing the first pixel 111 sensing the light of the first wavelength band that is the intermediate wavelength band, the first section R1 may extend toward the second meta-region 142 facing the second pixel 112 sensing the light of the second wavelength band that is the short wavelength band. The center of the main nano-structure in the first meta-region 141 may be located only in the first section R1 and not located outside of the first section R1. For example, a number of main nano-structures having the centers located in other sections than the first section R1 in the first meta-region 141 is 0. The center and the outer surface of the main nano-structure may be both located in the first section R1, but the center of the main nano-structure may be only located in the first section R1 and the outer surface may partially protrude outside of the first section R1.

In the second meta-region 142, a second section R2 in which the center of the main nano-structure is located may have a square shape located at the center of the second meta-region 142 in the first and second directions. The center of the second section R2 in the first and second directions may coincide with the center of the second meta-region 142 in the first and second directions. Also, four sides of the second section R2 may be parallel to facing sides of the second meta-region 142. The widths of the second section R2 in the first direction and the second direction may be 1/2 of the pixel pitch P. The center point of the main nano-structure in the second meta-region 142 may be located only in the second section R2 and not located outside of the second section R2. For example, the number of main nano-structures having the centers located in other sections than the second section R2 in the second meta-region 142 is 0.

In the third meta-region 143, a third section R3 in which the center of the main nano-structure is located may include a first portion defined along a rim of the third meta-region 143 in the third meta-region 143, a second portion extending along a center line of the third meta-region 143 in the first direction, and a third portion extending along a center line of the third meta-region 143 in the second direction. For example, the first portion of the third section R3 may continuously extend along four edges (sides) of the third meta-region 143 in the third meta-region 143. A width of each portion of the third section R3 may be 1/8 of the pixel pitch P. For example, in the third section R3, two components of the first portion adjacent to the boundary with the first meta-region 141 extend along the first direction toward the fourth meta-region 144 and may have a width of P/8 in the second direction, and in the third section R3, two components of the first portion adjacent to the boundary with the fourth meta-region 144 may extend in the second direction toward the first meta-region 141 and may have a width of P/8 in the first direction. Also, in the third section R3, a second portion extending toward the fourth meta-region 144 in the first direction from the center of the third meta-region 143 in the second direction may have a width of P/8 in the second direction, and a third portion extending toward the first meta-region 141 in the second direction from the center of the third meta-region 143 in the first direction may have a width of P/8 in the first direction. In the third section R3, the second portion extending from the center of the third meta-region 143 in the first direction and the third portion extending from the center of the third meta-region 143 in the second direction may cross each other at the center of the third meta-region 143.

In the fourth meta-region 144, a fourth section R4 in which the center point of the main nano-structure is located may have a rectangular shape extending along the second direction from the center of the fourth meta-region 144 in the first direction. For example, the fourth section R4 may be a rectangle in which a width in the second direction is greater than a width in the first direction. The center of the fourth section R4 in the first direction may coincide with the center of the fourth meta-region 144 in the first direction. A width of the fourth section R4 in the second direction is equal to a width of the fourth meta-region 144 in the second direction, and a width in the first direction may be 1/4 of the pixel pitch P. Therefore, an end portion of the fourth section R4 in the second direction may come into contact with a boundary between the fourth meta-region 144 and the second meta-region 142. For example, in the fourth meta-region 144 facing the fourth pixel 114 sensing the light of the first wavelength band that is the intermediate wavelength band, the fourth section R4 may extend toward the second meta-region 142 facing the second pixel 112 sensing the light of the second wavelength band that is the short wavelength band. Therefore, in the fourth meta-region 144, the fourth section R4 may have a shape rotated by a 90-degree angle with respect to the first section R1 in the first meta-region 141.

In addition, the nano-structures other than the main nano-structure, for example, the nano-structures having the CD (e.g., cross-sectional diameter or cross-sectional width) being less than a certain reference value may be arranged in arbitrary regions in the first to fourth meta-regions 141 to 144. For example, the center of the nano-structure having the CD of less than or equal to 90 nm or the CD being less than 1/20 of the pixel pitch P or less than 1/10 of the sub-pixel pitch may be located on the outside of the first to fourth sections R1 to R4 in the first to fourth meta-regions 141 to 144.

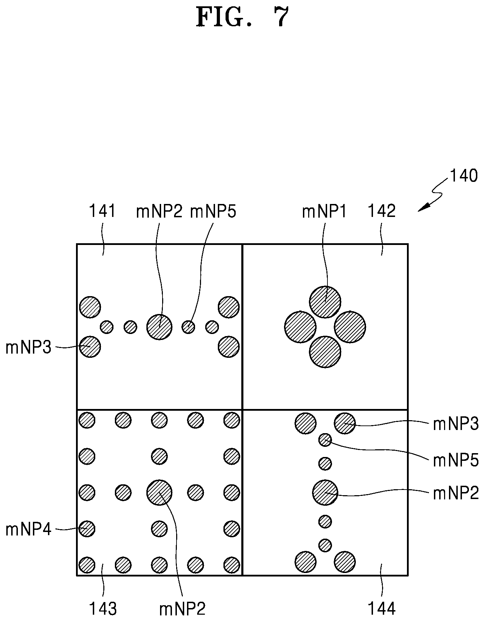

FIG. 7 is a plan view showing an example of one unit meta-pattern in the nano-photonic lens array 140 of FIG. 6. Referring to FIG. 7, the nano-photonic lens array 140 may include a plurality of nano-structures that are respectively arranged in the first to fourth meta-regions 141, 142, 143, and 144 so as to color-separate the incident light and condense the separated light. The plurality of nano-structures may be disposed such that a phase of light transmitting through the nano-photonic lens array 140 is changed according to a position on the nano-photonic lens array 140. A phase profile of the transmitted light, which is implemented by the nano-photonic lens array 140, may be determined according to a CD (e.g., cross-sectional width or cross-sectional diameter), cross-sectional shape, and a height of each of the nano-structures, and the arrangement type of the plurality of nano-structures. Also, the behavior of the light passing through the nano-photonic lens array 140 may be determined according to the phase profile of the transmitted light. For example, the plurality of nano-structures may be disposed to form a phase profile allowing the light transmitted through the nano-photonic lens array 140 to be separated according to wavelengths and condensed.

In an example, the nano-photonic lens array 140 may include a plurality of first main nano-structures mNP1 having a first CD, a plurality of second main nano-structures mNP2 having a second CD that is less than the first CD, a plurality of third main nano-structures mNP3 having a third CD less than the second CD, a plurality of fourth main nano-structures mNP4 having a fourth CD less than the third CD, and a plurality of fifth main nano-structures mNP5 having a fifth CD less than the fourth CD. The first to fifth main nano-structures mNP1, mNP2, mNP3, mNP4, and mNP5 may be arranged differently in the first meta-region 141, the second meta-region 142, the third meta-region 143, and the fourth meta-region 144.

The first meta-region 141 may include the second, third, and fifth main nano-structures mNP2, mNP3, and mNP5. In the first meta-region 141, the center points of the second, third, and fifth main nano-structures mNP2, mNP3, and mNP5 may be located in the first section R1 described above. For example, the second main nano-structure mNP2 may be arranged at the center of the first meta-region 141. The second, third, and fifth main nano-structures mNP2, mNP3, and mNP5 may be arranged in the first meta-region 141 in a 2-fold symmetry. For example, the second, third, and fifth main nano-structures mNP2, mNP3, and mNP5 may be arranged in the first meta-region 141 to be symmetrical in the first direction and the second direction.

The second meta-region 142 may include four first main nano-structures mNP1. In the second meta-region 142, the center points of the first main nano-structures mNP1 may be located in the second section R2 described above. Also, four first main nano-structures mNP1 may be arranged in the second meta-region 142 in a 4-fold symmetry structure. For example, the four first main nano-structures mNP1 may be arranged in the second meta-region 142 to be symmetrical in the first direction, second direction, and two diagonal directions.

The third meta-region 143 may include the second main nano-structure mNP2 and a plurality of fourth main nano-structures mNP4. In the third meta-region 143, the center points of the second main nano-structure mNP2 and the plurality of fourth main nano-structures mNP4 may be located in the third section R3 described above. For example, the second main nano-structure mNP2 may be arranged at the center of the third meta-region 143. The second main nano-structure mNP2 and the plurality of fourth main nano-structures mNP4 may be arranged in the third meta-region 143 in a 4-fold symmetry structure. For example, the second main nano-structure mNP2 and the plurality of fourth main nano-structures mNP4 may be arranged in the third meta-region 143 to be symmetrical in the first direction, second direction, and two diagonal directions.

The fourth meta-region 144 may include the second, third, and fifth main nano-structures mNP2, mNP3, and mNP5. In the fourth meta-region 144, the center points of the second, third, and fifth main nano-structures mNP2, mNP3, and mNP5 may be located in the fourth section R4 described above. For example, the second main nano-structure mNP2 may be arranged at the center of the fourth meta-region 144. The second, third, and fifth main nano-structures mNP2, mNP3, and mNP5 may be arranged in the fourth meta-region 144 in a 2-fold symmetry structure. For example, the second, third, and fifth main nano-structures mNP2, mNP3, and mNP5 may be arranged in the fourth meta-region 144 to be symmetrical in the first direction and the second direction. For example, the arrangement type of the second main nano-structure mNP2, the third main nano-structure mNP3, and the fifth main nano-structure mNP5 in the fourth meta-region 144 may be rotated by a 90-degree angle with respect to the arrangement type of the second main nano-structure mNP2, the third main nano-structure mNP3, and the fifth main nano-structure mNP5 in the first meta-region 141.

The first to fifth main nano-structures mNP1, mNP2, mNP3, mNP4, and mNP5 may have cross-sectional diameters or cross-sectional widths less than the wavelength of the visible ray. The first to fifth main nano-structures mNP1, mNP2, mNP3, mNP4, and mNP5 may have cross-sectional diameters or cross-sectional widths less than the wavelength of, for example, the blue light. For example, the CD (cross-sectional width or cross-sectional diameter) of the first to fifth main nano-structures mNP1, mNP2, mNP3, mNP4, and mNP5 may be less than or equal to 300 nm, 250 nm, or 200 nm, and greater than or equal to 90 nm. A height of the first to fifth main nano-structures mNP1, mNP2, mNP3, mNP4, and mNP5 may be about 500 nm to about 1,500 nm, and may be greater than the cross-sectional width.

The first to fifth main nano-structures mNP1, mNP2, mNP3, mNP4, and mNP5 may include a material having a relatively high refractive index as compared with a peripheral material and relatively low absorbent rate in the visible ray band. For example, the first to fifth main nano-structures mNP1, mNP2, mNP3, mNP4, and mNP5 may include c-Si, p-Si, a-Si, and a group III-V compound semiconductor (gallium phosphide (GaP), gallium nitride (GaN), gallium arsenide (GaAs), etc.), silicon carbide (SiC), titanium oxide (TiO₂), silicon nitride (SiN₃), zinc sulfide (ZnS), zinc selenide (ZnSe), silicon nitride (SiN), and/or a combination thereof. Peripheries of the first to fifth main nano-structures mNP1, mNP2, mNP3, mNP4, and mNP5 may be filled with a dielectric material having a relatively low refractive index as compared with the first to fifth main nano-structures mNP1, mNP2, mNP3, mNP4, and mNP5 and a relatively low absorbent ratio in the visible ray band. For example, the dielectric material may include siloxane-based spin on glass (SOG), silicon oxide (SiO₂), aluminum oxide (Al₂O₃), air, etc.

The refractive index of the first to fifth main nano-structures mNP1, mNP2, mNP3, mNP4, and mNP5 may be greater than or equal to about 2.0 with respect to the light of about 630 nm wavelength, and the refractive index of the dielectric material may be about 1.0 to 2.0 with respect to the light of about 630 nm wavelength. Also, a difference between the refractive index of the first to fifth main nano-structures mNP1, mNP2, mNP3, mNP4, and mNP5 and the refractive index of the dielectric material may be greater than or equal to about 0.5. The first to fifth main nano-structures mNP1, mNP2, mNP3, mNP4, and mNP5 having the refractive index different from that of the peripheral material may change a phase of light passing through the first to fifth main nano-structures mNP1, mNP2, mNP3, mNP4, and mNP5. This is because of a phase delay occurring due to sub-wavelength dimensions of the first to fifth main nano-structures mNP1, mNP2, mNP3, mNP4, and mNP5, and a degree of the phase delay may be determined according to detailed dimensions, arrangement type, etc. of the first to fifth main nano-structures mNP1, mNP2, mNP3, mNP4, and mNP5.

FIG. 7 shows an example of the configuration of the nano-photonic lens array 140, and the nano-photonic lens array 140 may be formed in various shapes other than the example shown in FIG. 7. For example, in each of the first meta-region 141, the second meta-region 142, the third meta-region 143, and the fourth meta-region 144, the number, CDs, and arrangement types of the plurality of main nano-structures may be variously selected. However, the features that the arrangement types of the plurality of main nano-structures in the second meta-region 142 and the third meta-region 143 are different from each other, the plurality of main nano-structures are arranged in a 4-fold symmetry in the second meta-region 142 and the third meta-region 143, the plurality of main nano-structures are arranged in a 2-fold symmetry in the first meta-region 141 and the fourth meta-region 144, the arrangement type of the plurality of main nano-structures in the first meta-region 141 is rotated by a 90-degree angle with respect to the arrangement type of the plurality of main nano-structures in the fourth meta-region 144, and the center points of the plurality of main nano-structures are only located in the first section R1, the second section R2, the third section R3, and the fourth section R4 of the first meta-region 141, the second meta-region 142, the third meta-region 143, and the fourth meta-region 144, may be constantly maintained.

In FIG. 7, the main nano-structures are shown to have cylindrical shapes, but cross-sectional shapes of the main nano-structures are not limited thereto. For example, according to the design of the nano-photonic lens array 140, the main nano-structures may be formed in pillar shapes having various different cross-sectional shapes such as rectangular shapes, triangular shapes, cross shapes, or elliptical shapes. When the cross-sectional shapes of the main nano-structures are polygonal or elliptical, the CD of the main nano-structure may be defined as the maximum width of the main nano-structure. Therefore, in the descriptions provided below, the CD of the main nano-structure denotes a diameter when the cross-sectional shape of the main nano-structure is circular, and denotes the maximum width of the main nano-structure when the cross-sectional shape of the main nano-structure is polygonal or elliptical.

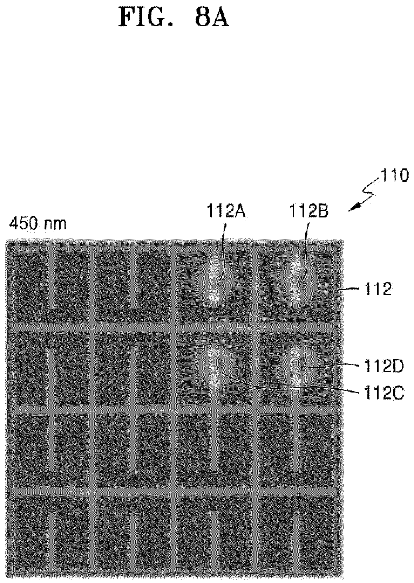

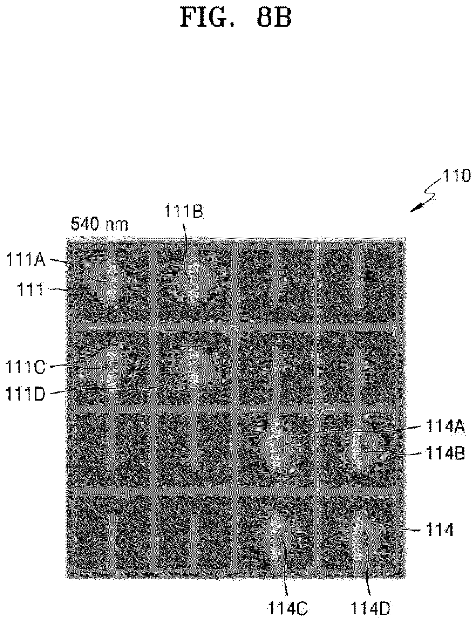

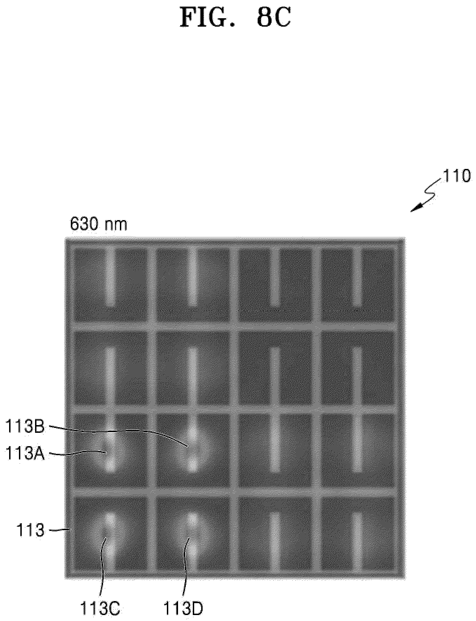

FIGS. 8A, 8B, and 8C are diagrams respectively showing examples of an optical spot of blue light, an optical spot of green light, and an optical spot of red light formed on the sensor substrate 110 by a nano-photonic lens array 140 including the unit meta-pattern shown in FIG. 7. The plurality of main nano-structures in the nano-photonic lens array 140 shown in FIG. 7 may be configured, at a position immediately after the incident light passes through the nano-photonic lens array 140, for example, the lower surface of the nano-photonic lens array 140, so that a phase of the blue light in the transmitted light is the largest at positions corresponding to the centers of the first sub-pixel 112A, the second sub-pixel 112B, the third sub-pixel 112C, and the fourth sub-pixel 112D of the second pixel 112. Also, the plurality of main nano-structures of the nano-photonic lens array 140 may be configured so that, at the lower surface of the nano-photonic lens array 140, a phase of the green light in the transmitted light is the largest at the positions corresponding to the centers of the first sub-pixel 111A, the second sub-pixel 111B, the third sub-pixel 111C, and the fourth sub-pixel 111D of the first pixel 111, and corresponding to the first sub-pixel 114A, the second sub-pixel 114B, the third sub-pixel 114C, and the fourth sub-pixel 114D of the fourth pixel 114. Also, the plurality of main nano-structures of the nano-photonic lens array 140 may be configured so that, at the lower surface of the nano-photonic lens array 140, a phase of the red light in the transmitted light is the largest at positions corresponding to the first sub-pixel 113A, the second sub-pixel 113B, the third sub-pixel 113C, and the fourth sub-pixel 113D of the third pixel 113. Then, the plurality of main nano-structures of the nano-photonic lens array 140 may be configured to form a plurality of light condensing areas in each of the first pixel 111, the second pixel 112, the third pixel 113, and the fourth pixel 114 by condensing the incident light incident on the nano-photonic lens array 140.

For example, as shown in FIG. 8A, in the incident light incident on the nano-photonic lens array 140, the blue light of the second wavelength band having the wavelength of about 450 nm may be condensed onto the centers of the first sub-pixel 112A, the second sub-pixel 112B, the third sub-pixel 112C, and the fourth sub-pixel 112D of the second pixel 112. Also, referring to FIG. 8B, in the incident light incident on the nano-photonic lens array 140, the green light of the first wavelength band having the wavelength of about 540 nm may be condensed onto the centers of the first sub-pixel 111A, the second sub-pixel 111B, the third sub-pixel 111C, and the fourth sub-pixel 111D of the first pixel 111, and corresponding to the first sub-pixel 114A, the second sub-pixel 114B, the third sub-pixel 114C, and the fourth sub-pixel 114D of the fourth pixel 114. Referring to FIG. 8C, in the incident light incident on the nano-photonic lens array 140, the red light of the third wavelength band having the wavelength of about 630 nm may be condensed onto the centers of the first sub-pixel 113A, the second sub-pixel 113B, the third sub-pixel 113C, and the fourth sub-pixel 113D of the third pixel 113. Accordingly, the incident light is separated by the nano-photonic lens array 140 according to wavelengths without loss and then provided respectively to the first to fourth pixels 111, 112, 113, and 114.

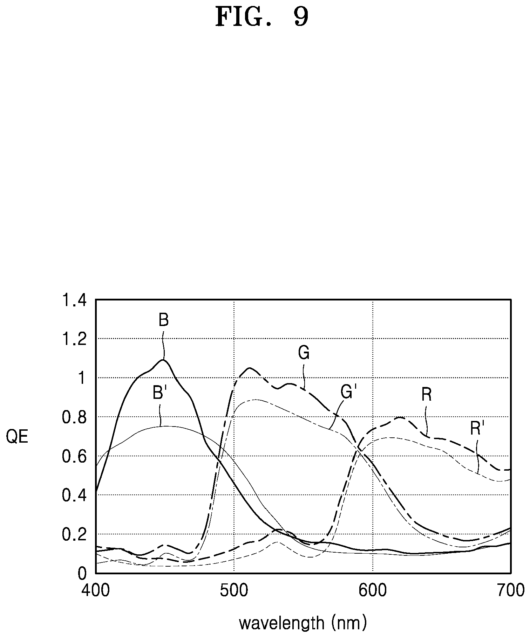

FIG. 9 is a graph showing an example of a quantum efficiency (QE) of an image sensor including the nano-photonic lens array 140 including the unit meta-pattern of FIG. 7. In FIG. 9, graphs indicated as B', G', and R' represent QEs with respect to the blue light, green light, and red light in the image sensor according to the comparative example without having the nano-photonic lens array, and graphs indicated as B, G, and R represent QEs with respect to the blue light, green light, and red light in the image sensor according to the embodiment. Referring to FIG. 9, the QE of the image sensor according to one or more embodiments with respect to the blue light, green light, and red light may be improved by about 10% as compared with the QE of the image sensor according to related example with respect to the blue light, green light, and red light.

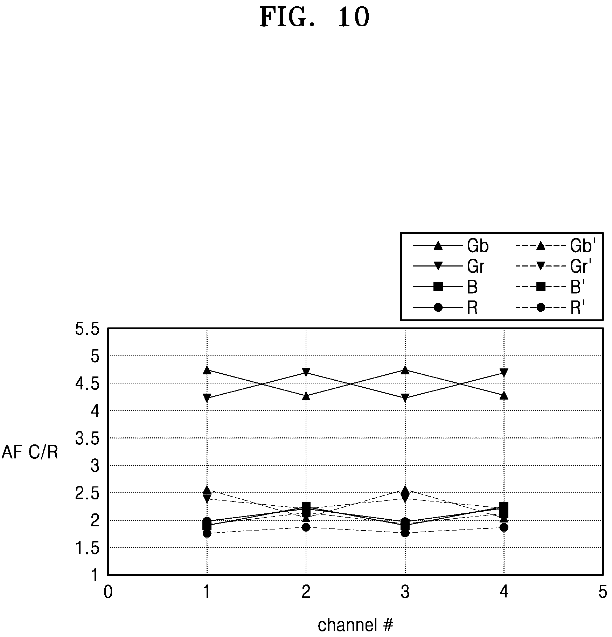

FIG. 10 is a graph showing an example of an auto-focusing (AF) contrast ratio of an image sensor including the nano-photonic lens array 140 including the unit meta-pattern of FIG. 7. An AF contrast ratio may be calculated (obtained) as a ratio (CL/CR) between an output signal CL from the first photosensitive cell C1 and an output signal CR from the second photosensitive cell C2 when the light is incident on the image sensor at an angle of 10°. In FIG. 10, a graph indicated by dashed lines represents the AF contrast ratio of an image sensor according to a related example, the image sensor including a spherical micro-lens array, instead of the nano-photonic lens array, and a graph indicated by solid lines represents an AF contrast ratio of the image sensor according to the embodiment. Also, Gb and Gb' are graphs showing the AF contrast ratio with respect to the green light measured in the first pixel 111, Gr and Gr' are graphs showing the AF contrast ratio with respect to the green light measured in the fourth pixel 114, B and B' are graphs showing the AF contrast ratio with respect to the blue light measured in the second pixel 112, and R and R' are graphs showing the AF contrast ratio with respect to the red light measured in the third pixel 113. Also, in FIG. 10, channel 1 denotes the AF contrast ratio measured in the second sub-pixel in each pixel, channel 2 denotes the AF contrast ratio measured in the first sub-pixel in each pixel, channel 3 denotes the AF contrast ratio measured in the fourth sub-pixel in each pixel, and channel 4 denotes the AF contrast ratio measured in the third sub-pixel in each pixel.

Referring to FIG. 10, in the image sensor according to the comparative example, the AF contrast ratio with respect to the red light is about 1.8, the AF contrast ratio with respect to the blue light is about 2, and the AF contrast ratio with respect to the green light is about 2.0 to 2.5. In the image sensor according to one or more embodiments, the AF contrast ratio with respect to the red light and the AF contrast ratio with respect to the blue light may be improved to about 2.0 to 2.3. In the image sensor according to one or more embodiments, the AF contrast ratio with respect to the green light may be greatly improved to about 4.5 in average. Also, because the characteristics of the channels are not substantially different from each other, relatively uniform characteristics may be obtained from the first to fourth sub-pixels in each pixel.

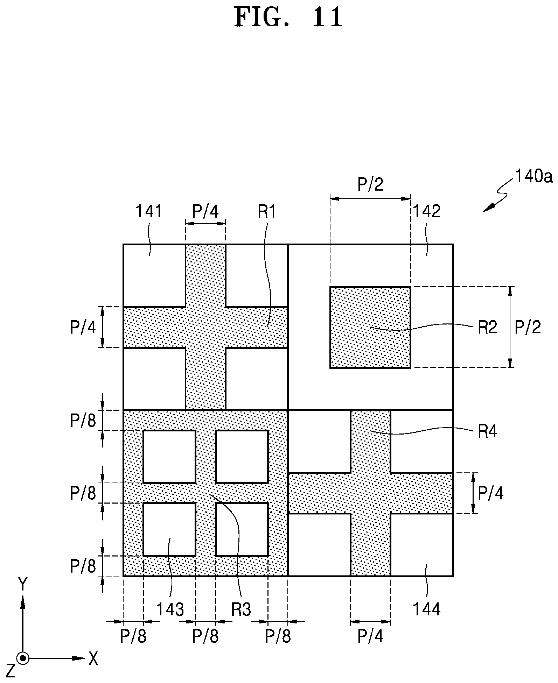

FIG. 11 is a diagram showing another example of a section in which main nano-structures are arranged in one unit meta-pattern of a nano-photonic lens array 140a. In the nano-photonic lens array 140a of FIG. 11, the second section R2 in the second meta-region 142 and the third section R3 in the third meta-region 143 are the same as the example of FIG. 6. The first section R1 of the first meta-region 141 in the nano-photonic lens array 140a may include a portion extending toward the second meta-region 142 along the first direction from the center of the first meta-region 141 in the second direction and a portion extending toward the third meta-region 143 along the second direction from the center of the first meta-region 141 in the first direction. A first direction end portion of the portion extending along the first direction comes into contact with the boundary between the first meta-region 141 and the second meta-region 142, and a second direction end portion of the portion extending along the second direction may come into contact with the boundary between the first meta-region 141 and the third meta-region 143. The portion extending along the first direction and the portion extending along the second direction may cross each other at the center of the first meta-region 141. A width in the second direction of the portion extending along the first direction and a width in the first direction of the portion extending along the second direction may be 1/4 of the pixel pitch P.

The shape of the fourth section R4 of the fourth meta-region 144 in the nano-photonic lens array 140a may be the same as the shape of the first section R1 of the first meta-region 141. For example, the fourth section R4 may include a portion extending toward the third meta-region 143 along the first direction from the center of the fourth meta-region 144 in the second direction, and a portion extending toward the second meta-region 142 along the second direction from the center of the fourth meta-region 144 in the first direction. A first direction end portion of the portion extending along the first direction comes into contact with the boundary between the fourth meta-region 144 and the third meta-region 143, and a second direction end portion of the portion extending along the second direction may come into contact with the boundary between the fourth meta-region 144 and the second meta-region 142. The portion extending along the first direction and the portion extending along the second direction may cross each other at the center of the fourth meta-region 144. A second direction width of the portion extending along the first direction and a first direction width of the portion extending along the second direction may be 1/4 of the pixel pitch P.

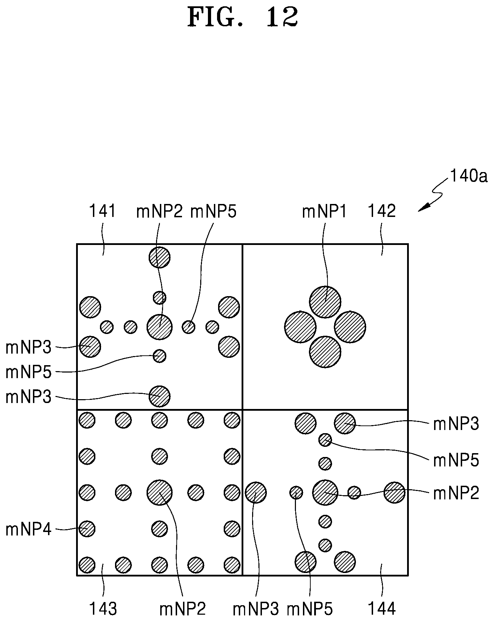

FIG. 12 is a plan view showing an example of one unit meta-pattern in the nano-photonic lens array 140a of FIG. 11. In the nano-photonic lens array 140a shown in FIG. 12, the arrangement of the main nano-structures in the second meta-region 142 and the arrangement of the main nano-structures in the third meta-region 143 are the same as the example shown in FIG. 7. When comparing with the example of FIG. 7, the third main nano-structure mNP3 and the fifth main nano-structure mNP5 may be further arranged on the portion extending along the second direction from the center of the first meta-region 141 in the first direction in the first meta-region 141. The arrangement of the third main nano-structure mNP3 and the fifth main nano-structure mNP5 on the portion extending along the second direction may be different from the arrangement of the third main nano-structure mNP3 and the fifth main nano-structure mNP5 on the portion extending along the first direction.

Also, when comparing with the example of FIG. 7, the third main nano-structure mNP3 and the fifth main nano-structure mNP5 may be further arranged on the portion extending along the first direction from the center of the fourth meta-region 144 in the second direction in the fourth meta-region 144. The arrangement of the third main nano-structure mNP3 and the fifth main nano-structure mNP5 on the portion extending along the first direction may be different from the arrangement of the third main nano-structure mNP3 and the fifth main nano-structure mNP5 on the portion extending along the second direction. In the example of FIG. 12, the arrangement type of the second main nano-structure mNP2, the third main nano-structure mNP3, and the fifth main nano-structure mNP5 in the fourth meta-region 144 may be rotated by a 90-degree angle with respect to the arrangement type of the second main nano-structure mNP2, the third main nano-structure mNP3, and the fifth main nano-structure mNP5 in the first meta-region 141.

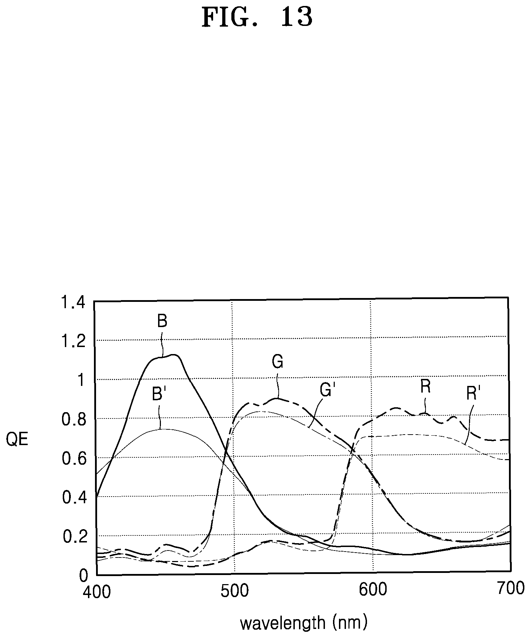

FIG. 13 is a graph showing an example of a QE of an image sensor including the nano-photonic lens array 140a including the unit meta-pattern of FIG. 12. In FIG. 13, graphs indicated as B', G', and R' represent QEs with respect to the blue light, green light, and red light in the image sensor according to the comparative example without having the nano-photonic lens array, and graphs indicated as B, G, and R represent QEs with respect to the blue light, green light, and red light in the image sensor according to the embodiment. Referring to FIG. 13, the QE of the image sensor according to the embodiment with respect to the blue light, green light, and red light may be improved by about 10% as compared with the QE of the image sensor according to the comparative example with respect to the blue light, green light, and red light. Also, when comparing with the QE of the image sensor according to the embodiment shown in FIG. 9, the QE with respect to the blue light increases in the image sensor including the nano-photonic lens array 140a shown in FIG. 12, but the QE with respect to the green light may be slightly reduced.

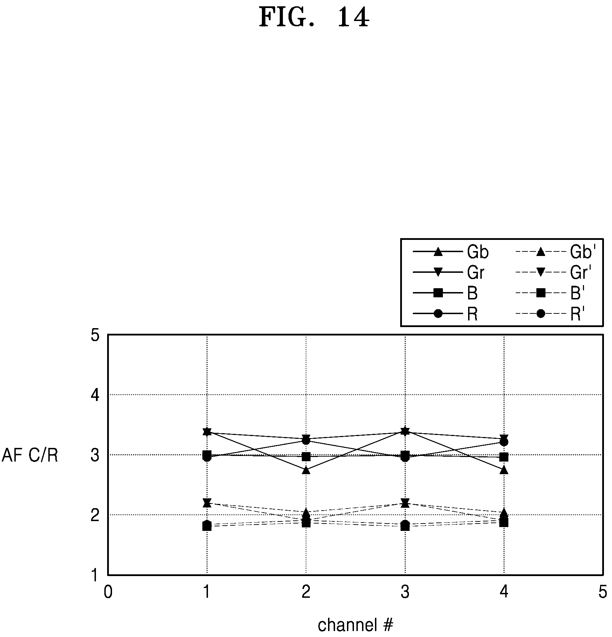

FIG. 14 is a graph showing an example of an auto-focusing signal contrast ratio of an image sensor including the nano-photonic lens array 140a including the unit meta-pattern of FIG. 12. When comparing with the AF contrast ratio of the image sensor according to the embodiment shown in FIG. 10, in the image sensor including the nano-photonic lens array 140a shown in FIG. 12, the AF contrast ratio with respect to the blue light and red light increases and the AF contrast ratio with respect to the green light slightly reduces, and thus, the AF contrast ratios with respect to the blue light, green light, and red light are nearly similar to one another. For example, in the image sensor including the nano-photonic lens array 140a shown in FIG. 12, an average of the AF contrast ratios with respect to the blue light, green light, and red light may be greater than or equal to about 3, for example, greater than or equal to 3.1.

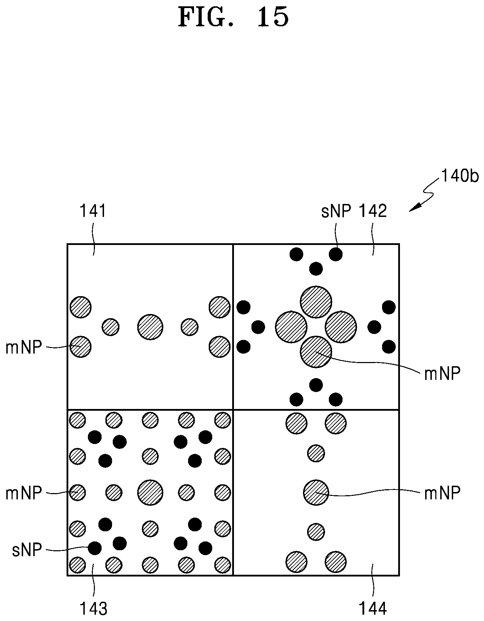

FIG. 15 is a plan view showing another example structure of one unit meta-pattern of the nano-photonic lens array of FIG. 6. Referring to FIG. 15, a nano-photonic lens array 140b may further include sub nano-structures having CD less than CD of the main nano-structures. The sub nano-structures denote nano-structures having CDs less than a certain reference value. For example, the nano-photonic lens array 140b shown in FIG. 15 may include the arrangement of the first to fifth main nano-structures mNP1, mNP2, mNP3, mNP4, and mNP5 similar to the example shown in FIG. 7, and additionally, may further include a plurality of sub nano-structures sNP arranged in the second meta-region 142 and a plurality of sub nano-structures sNP arranged in the third meta-region 143. The CD of the sub nano-structure sNP may be less than, e.g., 90 nm. As another example, a nano-structure having a CD less than 1/10 of the pixel pitch P may be defined as a sub nano-structure. The sub nano-structure sNP may allow a phase profile of a transmitted light formed by the nano-photonic lens array 140b to be smoother.

Center points of the sub nano-structures sNP may not need to be located only in the sections described with reference to FIG. 6. For example, the center points of the plurality of sub nano-structures sNP arranged in the second meta-region 142 may be located outside the second section R2, and the center points of the plurality of sub nano-structures sNP arranged in the third meta-region 143 may be located outside the third section R3. In this case, in the second meta-region 142 and the third meta-region 143, the arrangement of entire nano-structures including the sub nano-structures sNP may satisfy the 4-fold symmetry. For example, in the second meta-region 142 and the third meta-region 143, the entire nano-structures including the sub nano-structures sNP may be arranged to have symmetry in all of the first direction, second direction, and two diagonal directions.

As another example, in the second meta-region 142 and the third meta-region 143, the plurality of main nano-structures mNP may be arranged to be symmetrical in the first direction, second direction, and two diagonal directions, and at least one of the plurality of sub nano-structures sNP may be arranged in an arbitrary region in the second meta-region 142 and the third meta-region 143 without regard to the symmetry described above. For example, positions of some of the plurality of sub nano-structures sNP may not follow the above symmetry in order to finely adjust the phase profile of the transmitted light formed by the nano-photonic lens array 140b.

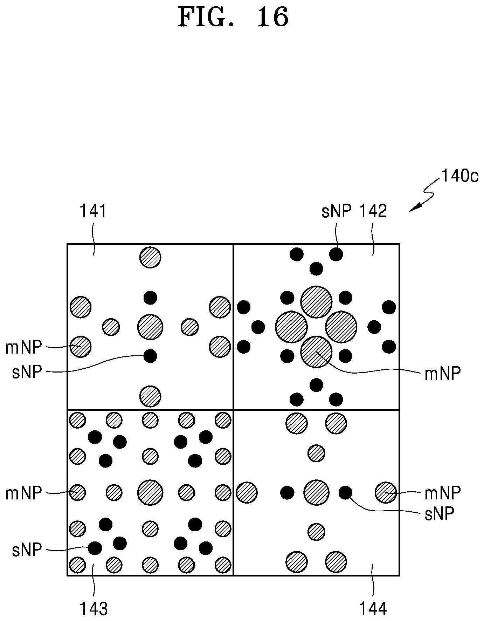

FIG. 16 is a plan view showing another example structure of one unit meta-pattern of the nano-photonic lens array of FIG. 11. Referring to FIG. 16, a nano-photonic lens array 140c may further include sub nano-structures having CD less than CD of the main nano-structures. For example, the nano-photonic lens array 140c shown in FIG. 16 may include the arrangement of the first to fifth main nano-structures mNP1, mNP2, mNP3, mNP4, and mNP5 similar to the example shown in FIG. 12, and additionally, may further include a plurality of sub nano-structures sNP arranged in the first meta-region 141, the second meta-region 142, the third meta-region 143, and the fourth meta-region 144. The center points of the plurality of sub nano-structures sNP may be located in the first to fourth sections R1, R2, R3, and R4 described with reference to FIG. 11, or may be located outside. In the first meta-region 141 and the fourth meta-region 144, the arrangement of the entire nano-structures including the sub nano-structures sNP may satisfy the 2-fold symmetry and may be rotated by about 90-degree angle. For example, in the first meta-region 141 and the fourth meta-region 144, the entire nano-structures including the sub nano-structures sNP may be arranged to have symmetry in the first direction and second direction. Also, in the second meta-region 142 and the third meta-region 143, the arrangement of entire nano-structures including the sub nano-structures sNP may satisfy the 4-fold symmetry.

As another example, in the first meta-region 141 and the fourth meta-region 144, the plurality of main nano-structures mNP may be only arranged to satisfy the 2-fold symmetry, and at least one of the plurality of sub nano-structures sNP may be arranged in an arbitrary section in the first and fourth meta-regions 141 and 144 without regard to the 2-fold symmetry structure. Also, in the second meta-region 142 and the third meta-region 143, the plurality of main nano-structures mNP may be only arranged to satisfy the 4-fold symmetry, and at least one of the plurality of sub nano-structures sNP may be arranged in an arbitrary section in the second and third meta-regions 142 and 143 without regard to the 4-fold symmetry structure.

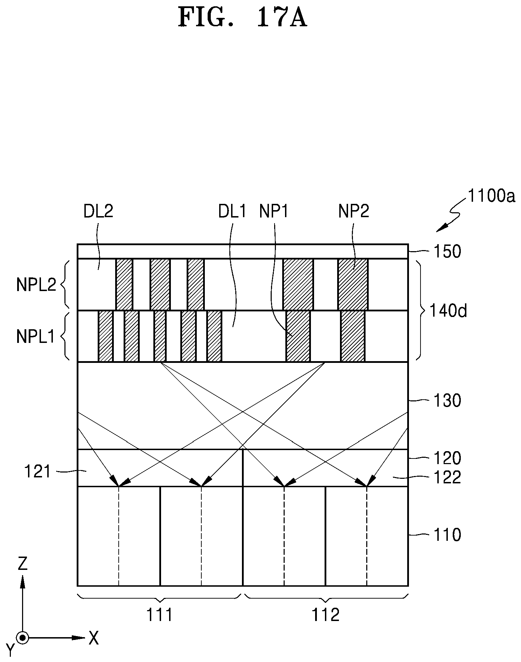

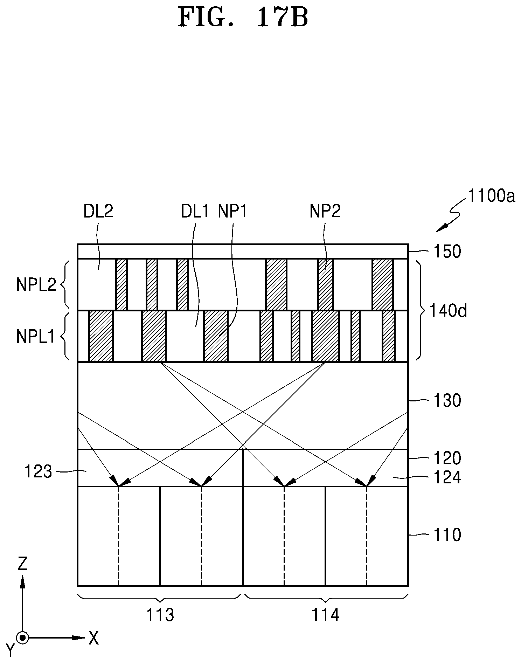

FIGS. 17A and 17B are cross-sectional views schematically showing a structure of a pixel array in an image sensor according to one or more other embodiments. Referring to FIGS. 17A and 17B, a nano-photonic lens array 140d of a pixel array 1100a according to one or more other embodiments may include two or more multi-layered structure. For example, the nano-photonic lens array 140d may include a first nano-structure layer NPL1 arranged on the spacer layer 130 and a second nano-structure layer NPL2 arranged on the first nano-structure layer NPL1. The first nano-structure layer NPL1 may include a plurality of first nano-structures NP1 and a first dielectric material layer DL1 filled between the plurality of first nano-structures NP1, and the second nano-structure layer NPL2 may include a plurality of second nano-structures NP2 and a second dielectric material layer DL2 filled between the plurality of second nano-structures NP2.

When the nano-photonic lens array includes two or more multi-layered structure, at least one layer may satisfy a designing condition about the section in which the main nano-structures are arranged described above with reference to FIGS. 6 to 11. Therefore, in the nano-photonic lens array 140d shown in FIGS. 17A and 17B, the center points of the main nano-structures in at least one layer between the first nano-structure layer NPL1 and the second nano-structure layer NPL2 may be located only in the first to fourth sections R1, R2, R3, and R4 described above with reference to FIG. 6 or FIG. 11.

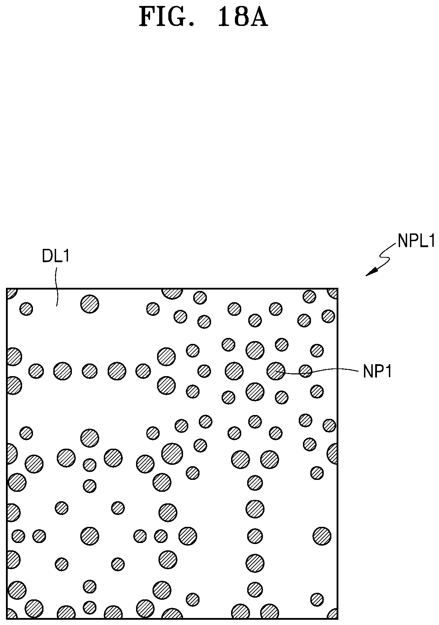

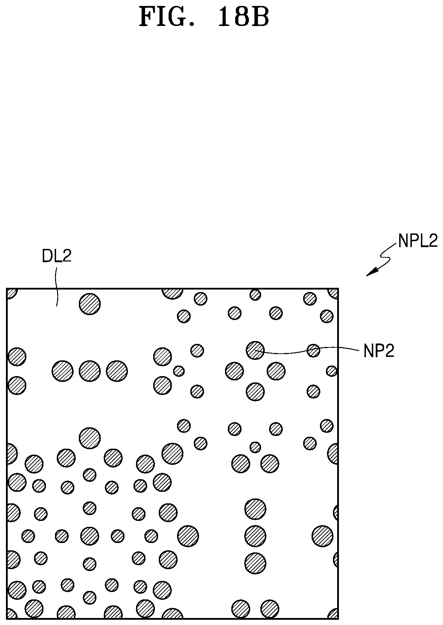

FIG. 18A is a plan view showing an example structure of a first nano-structure layer NPL1 in one unit meta-pattern of the nano-photonic lens array 140d of FIG. 6, and FIG. 18B is a plan view showing an example structure of a second nano-structure layer NPL2 in one unit meta-pattern of the nano-photonic lens array 140d of FIG. 6. In the first nano-structure layer NPL1 shown in FIG. 18A and the second nano-structure layer NPL2 shown in FIG. 18B, the arrangement of the plurality of first nano-structures NP1 and the arrangement of the plurality of second nano-structures NP2 may be slightly different from each other. The first nano-structure layer NPL1 and the second nano-structure layer NPL2 may include a plurality of main nano-structures and a plurality of sub nano-structures. For example, some of the plurality of first nano-structures NP1 in the first nano-structure layer NPL1 and the plurality of second nano-structures NP2 in the second nano-structure layer NPL2 may be main nano-structures and the other may be sub nano-structures. From among the plurality of first nano-structures NP1, the center points of the main nano-structures may be located only in the first to fourth sections R1, R2, R3, and R4 described above with reference to FIG. 6, or from among the plurality of second nano-structures NP2, the center points of the main nano-structures may be located only in the first to fourth sections R1, R2, R3, and R4 described above with reference to FIG. 6.

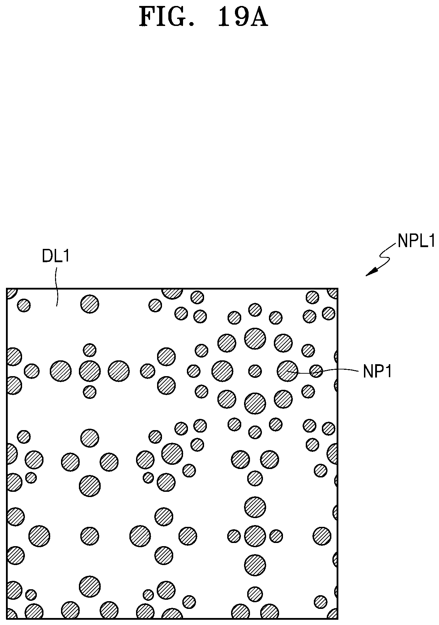

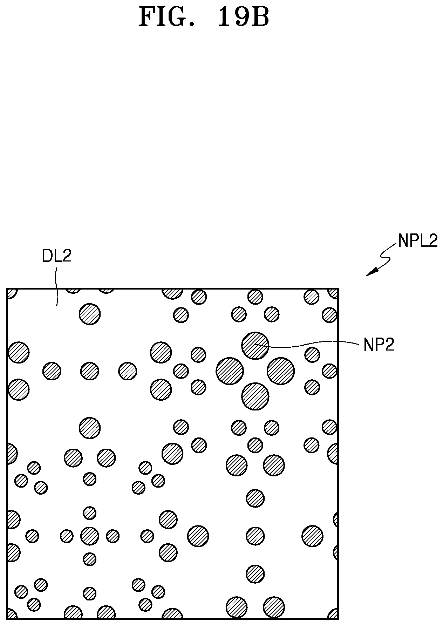

FIG. 19A is a plan view showing an example structure of a first nano-structure layer NPL1 in one unit meta-pattern of the nano-photonic lens array 140d of FIG. 11, and FIG. 19B is a plan view showing an example structure of a second nano-structure layer NPL2 in one unit meta-pattern of the nano-photonic lens array 140d of FIG. 11. From among the plurality of first nano-structures NP1 in the first nano-structure layer NPL1, the center points of the main nano-structures are located only in the first to fourth sections R1, R2, R3, and R4 described above with reference to FIG. 11, or from among the plurality of second nano-structures NP2 in the second nano-structure layer NPL2, the center points of the main nano-structures may be located only in the first to fourth sections R1, R2, R3, and R4 described above with reference to FIG. 11.

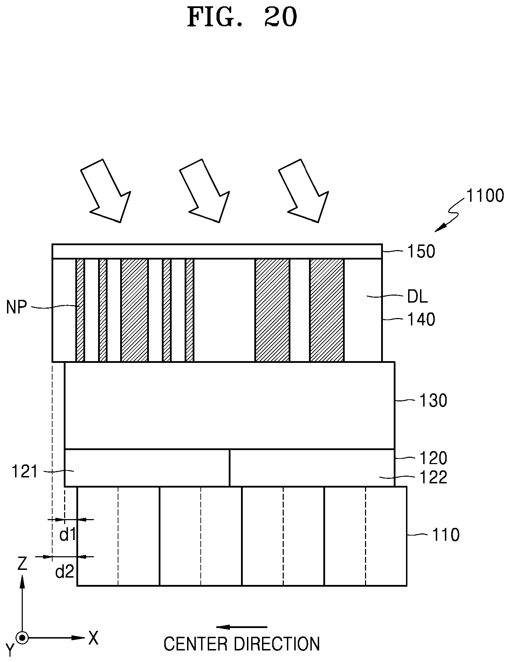

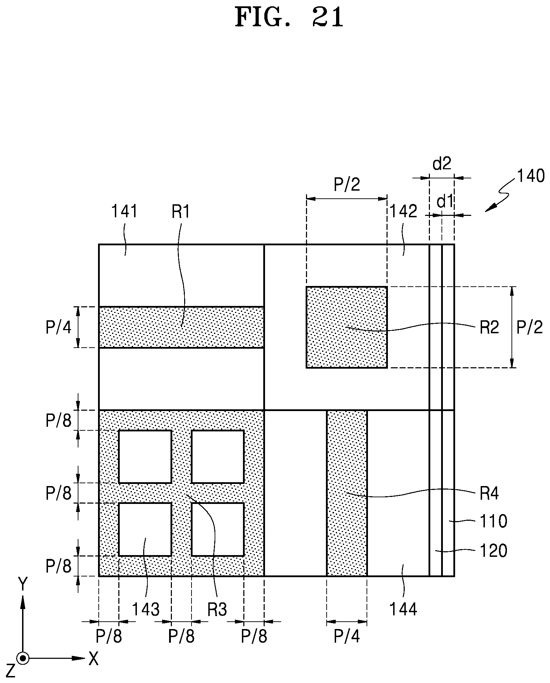

FIG. 20 is a cross-sectional view schematically showing a cross-sectional structure in a peripheral portion of a pixel array 1100 according to one or more other embodiments, and FIG. 21 is a diagram showing example of relative positions of a sensor substrate 110, a color filter layer 120, and a nano-photonic lens array 140 in a peripheral portion of the pixel array 1100 according to one or more other embodiments. Referring to FIGS. 20 and 21, in the periphery portion of the pixel array 1100 on which the incident light is obliquely incident, the first to fourth color filters 121, 122, 123, and 124 of the color filter layer 120 and the first to fourth meta-regions 141, 142, 143, and 144 of the nano-photonic lens array 140 may be shifted toward the center portion of the pixel array 1100 with respect to the first to fourth pixels 111, 112, 113, and 114 corresponding thereto.

For example, the first to fourth color filters 121, 122, 123, and 124 of the color filter layer 120 may be shifted by a first distance d1 toward the center portion of the pixel array 1100 with respect to the first to fourth pixels 111, 112, 113, and 114 corresponding thereto, and the first to fourth meta-regions 141, 142, 143, and 144 of the nano-photonic lens array 140 may be shifted by a second distance d2 toward the center portion of the pixel array 1100 with respect to the first to fourth pixels 111, 112, 113, and 114 corresponding thereto. The second distance d2, that is, the shifted distance of the first to fourth meta-regions 141, 142, 143, and 144, may be greater than the first distance d1 that is the shifted distance of the first to fourth color filters 121, 122, 123, and 124. Therefore, in the periphery portion of the pixel array 1100, boundaries of the pixel, color filter, and meta-region corresponding to one another may not be matched in the third direction. The shifted distances of the first to fourth color filters 121, 122, 123, and 124 and the first to fourth meta-regions 141, 142, 143, and 144 may increase away from the center of the pixel array 1100.

Then, the first to fourth sections R1, R2, R3, and R4 where the center points of the main nano-structures are located in the first to fourth meta-regions 141, 142, 143, and 144 may be also shifted toward the center portion of the pixel array 1100 as much as a second distance d2 with respect to the first to fourth pixels 111, 112, 113, and 114 corresponding thereto. In this case, the widths of the first to fourth sections R1, R2, R3, and R4 described above with reference to FIGS. 6 and 11 are maintained, and relatively positions with respect to the corresponding pixels may be only changed.

In the image sensor 1000 according to one or more embodiments, the nano-photonic lens array 140 may color-separate the incident light without absorbing or reflecting the incident light and then condense the color-separated light onto each pixel, and thus, the light utilization efficiency may be improved and the degradation in resolution may be reduced. Therefore, a size of one pixel or sizes of independent photosensitive cells in the pixel of the image sensor 1000 may be reduced, and thus, the image sensor 1000 having higher resolution may be provided. Also, according to one or more embodiments, an image processing algorithm in an image sensor according to the related art may be used while using the nano-photonic lens array 140. The image sensor 1000 according to one or more embodiments may form a camera module along with a module lens of various functions and may be utilized in various electronic apparatuses.

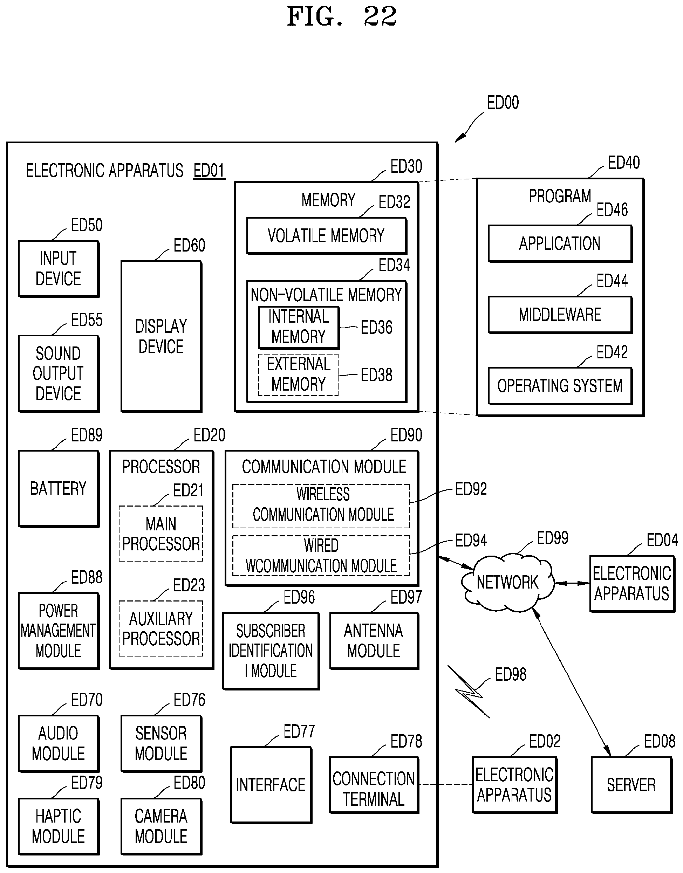

FIG. 22 is a block diagram showing an example of an electronic apparatus ED01 including an image sensor 1000. Referring to FIG. 22, in a network environment ED00, the electronic apparatus ED01 may communicate with another electronic apparatus ED02 via a first network ED98 (short-range wireless communication network, etc.), or may communicate with another electronic apparatus ED04 and/or a server ED08 via a second network ED99 (long-range wireless communication network, etc.) The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (the display device ED60, etc.) of the elements may be omitted or another element may be added. Some of the elements may be configured as one integrated circuit. For example, the sensor module ED76 (a fingerprint sensor, an iris sensor, an illuminance sensor, etc.) may be embedded and implemented in the display device ED60 (display, etc.).

The processor ED20 may control one or more elements (hardware, software elements, etc.) of the electronic apparatus ED01 connected to the processor ED20 by executing software (program ED40, etc.) and may perform various data processing or operations. As a part of the data processing or operations, the processor ED20 may load a command and/or data received from another element (sensor module ED76, communication module ED90, etc.) to a volatile memory ED32, may process the command and/or data stored in the volatile memory ED32, and may store result data in a non-volatile memory ED34. The non-volatile memory ED34 may include an internal memory ED36 and an external memory ED38. The processor ED20 may include a main processor ED21 a (central processing unit, an application processor, etc.) and an auxiliary processor ED23 (a graphics processing unit, an image signal processor, a sensor hub processor, a communication processor, etc.) that may operate independently from or along with the main processor ED21. The auxiliary processor ED23 may use less power than that of the main processor ED21 and may perform specific functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (the display device ED60, the sensor module ED76, the communication module ED90, etc.) of the elements in the electronic apparatus ED01. The auxiliary processor ED23 (an image signal processor, a communication processor, etc.) may be implemented as a part of another element (the camera module ED80, the communication module ED90, etc.) that is functionally related thereto.

The memory ED30 may store various data required by the elements (the processor ED20, the sensor module ED76, etc.) of the electronic apparatus ED01. The data may include, for example, input data and/or output data about software (program ED40, etc.) and commands related thereto. The memory ED30 may include the volatile memory ED32 and/or the non-volatile memory ED34. The non-volatile memory ED34 may include an internal memory ED36 and an external memory ED38.

The program ED40 may be stored as software in the memory ED30 and may include an operation system ED42, middleware ED44, and/or an application ED46.

The input device ED50 may receive commands and/or data to be used in the elements (the processor ED20, etc.) of the electronic apparatus ED01, from outside (a user, etc.) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include touch circuitry set to sense a touch, and/or a sensor circuit (pressure sensor, etc.) that is set to measure the strength of a force generated by the touch.

The audio module ED70 may convert sound into an electrical signal or vice versa. The audio module ED 70 may acquire sound through the input device ED50, or may output sound via the sound output device ED55 and/or a speaker and/or headphones of another electronic apparatus (the electronic apparatus ED02, etc.) connected directly or wirelessly to the electronic apparatus ED01.

The sensor module ED76 may sense an operating state (power, temperature, etc.) of the electronic apparatus ED01, or an outer environmental state (user state, etc.) and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (the electronic apparatus ED02, etc.) The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (the electronic apparatus ED02, etc.). The connection terminal ED78 may include an HDMI connector, a USB connector, an SD card connector, and/or an audio connector (headphones connector, etc.).

The haptic module ED79 may convert the electrical signal into a mechanical stimulation (vibration, motion, etc.) or an electric stimulation that the user may sense through a tactile or motion sensation. The haptic module ED79 may include a motor, a piezoelectric device and/or an electric stimulus device.

The camera module ED80 may capture a still image and a video. The camera module ED80 may include a lens assembly including one or more lenses, the image sensor 1000 of FIG. 1, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (the electronic apparatus ED02, the electronic apparatus ED04, the server ED08, etc.), and execution of communication through the established communication channel. The communication module ED90 may be operated independently from the processor ED20 (application processor, etc.) and may include one or more communication processors that support the direct communication and/or the wireless communication. The communication module ED90 may include a wireless communication module ED92 (a cellular communication module, a short-range wireless communication module, a global navigation satellite system (GNSS) communication module) and/or a wired communication module ED94 (a local area network (LAN) communication module, a power line communication module, etc.). From among the communication modules, a corresponding communication module may communicate with another electronic apparatus via the first network ED98 (short-range communication network such as Bluetooth, WiFi direct, or infrared data association (IrDA)) or a second network ED99 (long-range communication network such as a cellular network, Internet, or computer network (LAN, WAN, etc.)). Such above various kinds of communication modules may be integrated as one element (single chip, etc.) or may be implemented as a plurality of elements (a plurality of chips) separately from one another. The wireless communication module ED92 may identify and authenticate the electronic apparatus ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic apparatus, etc.). An antenna may include a radiator formed as a conductive pattern formed on a substrate (PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (RFIC, etc.) other than the antenna may be included as a part of the antenna module ED97.

Some of the elements may be connected to one another via the communication method among the peripheral devices (bus, general purpose input and output (GPIO), serial peripheral interface (SPI), mobile industry processor interface (MIPI), etc.) and may exchange signals (commands, data, etc.).

The command or data may be transmitted or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To do this, for example, a cloud computing, a distributed computing, or a client-server computing technique may be used.

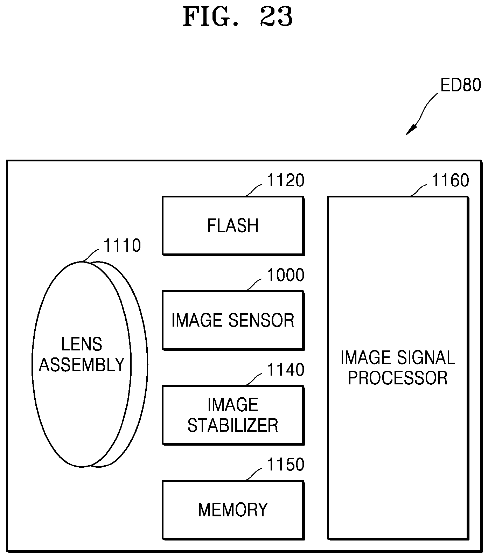

FIG. 23 is a block diagram showing an example of the camera module ED80 included in the electronic apparatus ED01 of FIG. 22. Referring to FIG. 23, the camera module ED80 may include a lens assembly 1110, a flash 1120, an image sensor 1000, an image stabilizer 1140, a memory 1150 (buffer memory, etc.), and/or an image signal processor 1160. The lens assembly 1110 may collect light emitted from an object that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (viewing angle, focal length, auto-focus, F number, optical zoom, etc.) or different lens properties. The lens assembly 1110 may include a wide-angle lens or a telephoto lens.

The flash 1120 may emit light that is used to strengthen the light emitted or reflected from the object. The flash 1120 may emit visible light or infrared-ray light. The flash 1120 may include one or more light-emitting diodes (red-green-blue (RGB)) LED, white LED, infrared LED, ultraviolet LED, etc.), and/or a Xenon lamp. The image sensor 1000 may be the image sensor described above with reference to FIG. 1, and converts the light emitted or reflected from the object and transferred through the lens assembly 1110 into an electrical signal to obtain an image corresponding to the object.

The image stabilizer 1140, in response to a motion of the camera module ED80 or the electronic apparatus ED01 including the camera module ED80, moves one or more lenses included in the lens assembly 1110 or the image sensor 1000 in a certain direction or controls the operating characteristics of the image sensor 1000 (adjusting of a read-out timing, etc.) in order to compensate for a negative influence of the motion. The image stabilizer 1140 may sense the movement of the camera module ED80 or the electronic apparatus ED01 by using a gyro sensor (not shown) or an acceleration sensor (not shown) disposed in or out of the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (Bayer-patterned data, high-resolution data, etc.) is stored in the memory 1150, and a low-resolution image is only displayed. Then, original data of a selected image (user selection, etc.) may be transferred to the image signal processor 1160. The memory 1150 may be integrated with the memory ED30 of the electronic apparatus ED01, or may include an additional memory that is operated independently.

The image signal processor 1160 may perform image treatment on the image obtained through the image sensor 1000 or the image data stored in the memory 1150. The image processing may include a depth map generation, a three-dimensional modeling, a panorama generation, extraction of features, an image combination, and/or an image compensation (noise reduction, resolution adjustment, brightness adjustment, blurring, sharpening, softening, etc.). The image signal processor 1160 may perform controlling (exposure time control, read-out timing control, etc.) of the elements (image sensor 1000, etc.) included in the camera module ED80. Also, the image signal processor 1160 may generate a full-color image by executing the above demosaic algorithm. For example, when the demosaic algorithm is executed to generate the full-color image, the image signal processor 1160 may reconstruct most of the spatial resolution information by using an image signal of a green channel or yellow channel having high spatial sampling rate.

The image processed by the image signal processor 1160 may be stored again in the memory 1150 for additional process, or may be provided to an external element of the camera module ED80 (e.g., the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 undergoes through an additional image processing by the processor ED20 and then may be displayed on the display device ED60.

Also, the image signal processor 1160 may receive two output signals independently from the adjacent photosensitive cells in each pixel or sub-pixel of the image sensor 1000, and may generate an auto-focusing signal from a difference between the two output signals. The image signal processor 1160 may control the lens assembly 1110 such that the focus of the lens assembly 1110 may be accurately formed on the surface of the image sensor 1000 based on the auto-focusing signal.

The electronic apparatus ED01 may further include one or a plurality of camera modules having different properties or functions. The camera module may include elements similar to those of the camera module ED80 of FIG. 23, and the image sensor included in the camera module may be implemented as a CCD sensor and/or a CMOS sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

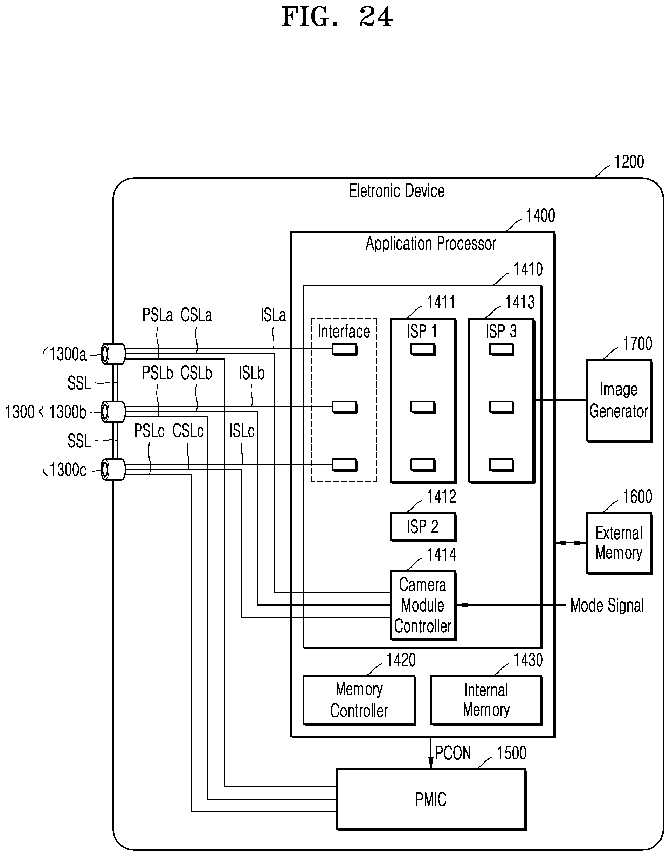

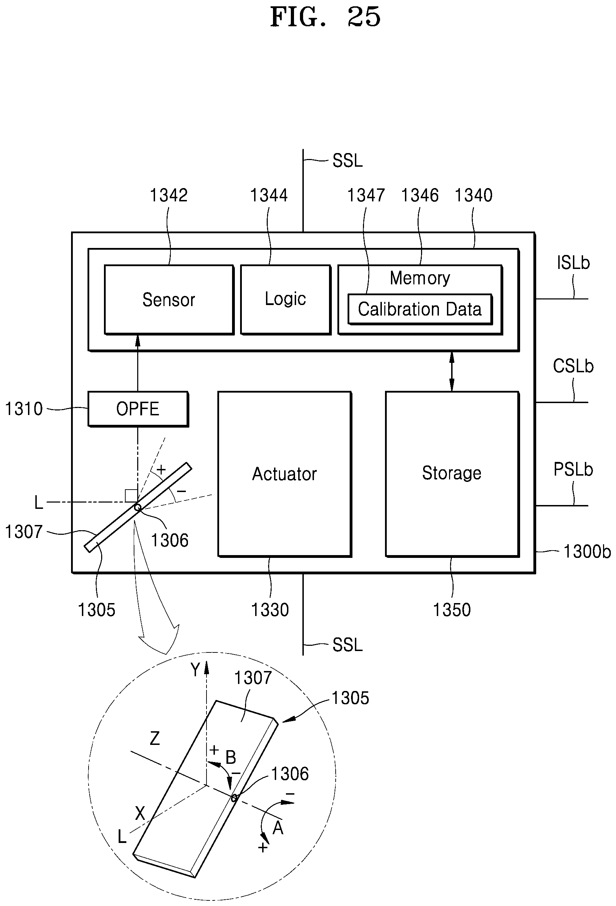

FIG. 24 is a block diagram of an electronic device 1200 including a multi-camera module, and FIG. 25 is a detailed block diagram of the camera module in the electronic device shown in FIG. 24.

Referring to FIG. 24, the electronic device 1200 may include a camera module group 1300, an application processor 1400, a power management integrated circuit (PMIC) 1500, an external memory 1600, and an image generator 1700.

The camera module group 1300 may include a plurality of camera modules 1300a, 1300b, and 1300c. Although the drawings show an example in which three camera modules 1300a, 1300b, and 1300c are arranged, one or more embodiments are not limited thereto. In some embodiments, the camera module group 1300 may be modified to include only two camera modules. Also, in some embodiments, the camera module group 1300 may be modified to include n (n is a natural number greater than or equal to 4) camera modules.

Hereinafter, detailed configuration of one camera module 1300b is described in detail below with reference to FIG. 25, but the description provided below may be also applied to the other camera modules 1300a and 1300c according to the embodiments.

Referring to FIG. 25, the camera module 1300b may include a prism 1305, an optical path folding element (OPFE) 1310, an actuator 1330, an image sensing device 1340, and a storage 1350.

The prism 1305 may include a reflecting surface 1307 having a light-reflecting material and may deform a path of light L incident from outside.

In some embodiments, the prism 1305 may change the path of the light L incident in the first direction (X-direction) into a second direction (Y-direction) that perpendicularly crosses the first direction (X-direction). Also, the prism 1305 may rotate the reflecting surface 1307 having the light-reflecting material about a center axis 1306 in a direction A, or about the center axis 1306 in a direction B such that the path of the light L incident in the first direction (X-direction) may be changed to the second direction (Y-direction) perpendicularly crossing the first direction (X-direction). Here, the OPFE 1310 may also move in the third direction (Z-direction) that perpendicularly crosses the first direction (X-direction) and the second direction (Y-direction).

In some embodiments, as shown in the drawings, the maximum rotation angle of the prism 1305 in the direction A is less than or equal to 15° in the positive A direction and is greater than 15° in the negative A direction, but the embodiments are not limited thereto.

In some embodiments, the prism 1305 may be moved by the angle of about 20°, or between 10° to 20° or 15° to 20° in the positive or negative B direction. Here, the moving angle is the same in the positive or negative B direction, or may be similar within a range of about 1°.

In some embodiments, the prism 1305 may move the reflecting surface 1307 of the light-reflective material in the third direction that is parallel to the direction in which the center axis 1306 extends.

The OPFE 1310 may include, for example, optical lenses formed as m groups (here, m is a natural number). Here, m lenses move in the second direction (Y-direction) and may change an optical zoom ratio of the camera module 1300b. For example, when a basic optical zoom ratio of the camera module 1300b is Z and m optical lenses included in the OPFE 1310 move, the optical zoom ratio of the camera module 1300b may be changed to greater than or equal to 3Z, 5Z, or 10Z.

The actuator 1330 may move the OPFE 1310 or the optical lens (hereinafter, referred to as optical lens) to a certain position. For example, the actuator 1330 may adjust the position of the optical lens such that the image sensor 1342 may be located at a focal length of the optical lens for exact sensing operation.

An image sensing device 1340 may include the image sensor 1342, a control logic 1344, and a memory 1346. The image sensor 1342 may sense an image of a sensing target by using the light L provided through the optical lens. The control logic 1344 may control the overall operation of the camera module 1300b. For example, the control logic 1344 may control the operations of the camera module 1300b according to a control signal provided through a control signal line CSLb.

For example, the image sensor 1342 may include the color separating lens array or the nano-photonic lens array described above. The image sensor 1342 may receive more signals separated according to wavelengths in each pixel by using the color separating lens array based on the nano-structures. Due to the above effects, the optical intensity required to generate high quality images of high resolution and under the low illuminance may be secured.

The memory 1346 may store information that is necessary for the operation of the camera module 1300b, e.g., calibration data 1347. The calibration data 1347 may include information that is necessary to generate image data by using the light L provided from outside through the camera module 1300b. The calibration data 1347 may include, for example, information about the degree of rotation described above, information about the focal length, information about an optical axis, etc. When the camera module 1300b is implemented in the form of a multi-state camera of which the focal length is changed according to the position of the optical lens, the calibration data 1347 may include information related to focal length values of the optical lens according to each position (or state) and auto-focusing.

The storage 1350 may store image data sensed through the image sensor 1342. The storage 1350 may be disposed out of the image sensing device 1340 and may be stacked with a sensor chip included in the image sensing device 1340. In some embodiments, the storage 1350 may be implemented as electrically erasable programmable read-only memory (EEPROM), but one or more embodiments are not limited thereto.

Referring to FIGS. 24 and 25, in some embodiments, each of the plurality of camera modules 1300a, 1300b, and 1300c may include the actuator 1330. Accordingly, each of the plurality of camera modules 1300a, 1300b, and 1300c may include the calibration data 1347 that is the same as or different from the others, according to the operation of the actuator 1330 included therein.

In some embodiments, one (for example, 1300b) of the plurality of camera modules 1300a, 1300b, and 1300c may be a camera module in a folded lens type including the prism 1305 and the OPFE 1310 described above, and the other camera modules (for example, 1300a and 1300c) may be vertical type camera modules not including the prism 1305 and the OPFE 1310. However, the disclosure is not limited thereto.

In some embodiments, one (for example, 1300c) of the plurality of camera modules 1300a, 1300b, and 1300c may be a depth camera of a vertical type, which extracts depth information by using infrared ray (IR).

In some embodiments, at least two camera modules (e.g., 1300a and 1300b) from among the plurality of camera module 1300a, 1300b, and 1300c may have different fields of view. In this case, for example, the optical lenses of the at least two camera modules (e.g., 1300a and 1300b) from among the plurality of camera modules 1300a, 1300b, and 1300c may be different from each other, but one or more embodiments are not limited thereto.

Also, in some embodiments, the plurality of camera modules 1300a, 1300b, and 1300c may have different fields of view from one another. In this case, the optical lenses respectively included in the plurality of camera modules 1300a, 1300b, and 1300c may be different from one another, but the inventive concept is not limited thereto.

In some embodiments, the plurality of camera modules 1300a, 1300b, and 1300c may be physically isolated from one another. That is, the sensing region of one image sensor 1342 may not be divided and used by the plurality of camera modules 1300a, 1300b, and 1300c, but the plurality of camera modules 1300a, 1300b, and 1300c may each have an independent image sensor 1342 provided therein.

Referring back to FIG. 24, the application processor 1400 may include an image processing device 1410, a memory controller 1420, and an internal memory 1430. The application processor 1400 may be separately implemented from the plurality of camera modules 1300a, 1300b, and 1300c. For example, the application processor 1400 and the plurality of camera modules 1300a, 1300b, and 1300c may be separately implemented as separate semiconductor chips.

The image processing device 1410 may include a plurality of image processors 1411, 1412, and 1413, and a camera module controller 1414.

The image data generated by each of the camera modules 1300a, 1300b, and 1300c may be provided to the image processing device 1410 via separate image signal lines ISLa, ISLb, and ISLc, respectively. The image data transfer may be carried out by using a camera serial interface (CSI) based on a mobile industry processor interface (MIPI), for example, but is not limited thereto.

The image data transferred to the image processing device 1410 may be stored in an external memory 1600 before being transferred to the image processors 1411 and 1412. The image data stored in the external memory 1600 may be provided to the image processor 1411 and/or the image processor 1412. The image processor 1411 may correct the image data in order to generate video. The image processor 1412 may correct the image data in order to generate still images. For example, the image processors 1411 and 1412 may perform a pre-processing operation such as a color calibration, a gamma calibration on the image data.

The image processor 1411 may include sub-processors. When the number of sub-processors is equal to the number of camera modules 1300a, 1300b, and 1300c, each of the sub-processors may process the image data provided from one camera module. When the number of sub-processors is less than the number of camera modules 1300a, 1300b, and 1300c, at least one of the sub-processors may process the image data provided from a plurality of camera module by using a timing-sharing process. The image data processed by the image processor 1411 and/or the image processor 1412 may be stored in the external memory 1600 before being transferred to the image processor 1413. The image data stored in the external memory 1600 may be transferred to the image processor 1412. The image processor 1412 may perform a post-processing operation such as a noise calibration, a sharpen calibration, etc. on the image data.

The image data processed in the image processor 1413 may be provided to the image generator 1700. The image generator 1700 may generate a final image by using the image data provided from the image processor 1413 according to image generating information or a mode signal.

In detail, the image generator 1700 may generate an output image by merging at least parts of the image data generated by the camera modules 1300a, 1300b, and 1300c having different fields of view, according to image generating information or the mode signal. Also, the image generator 1700 may generate the output image by selecting one of pieces of image data generated by the camera modules 1300a, 1300b, and 1300c having different fields of view, according to image generating information or the mode signal.

In some embodiments, the image generating information may include a zoom signal or a zoom factor. Also, in some embodiments, the mode signal may be, for example, a signal based on a mode selected by a user.

When the image generating information is a zoom signal (zoom factor) and the camera modules 1300a, 1300b, and 1300c have different fields of view (angles of view) from one another, the image generator 1700 may perform different operations according to the kind of zoom signal. For example, when the zoom signal is a first signal, the image data output from the camera module 1300a is merged with the image data output from the camera module 1300c, and then, the output image may be generated by using the merged image signal and the image data output from the camera module 1300b and not used in the merge. When the zoom signal is a second signal that is different from the first signal, the image generator 1700 may not perform the image data merging, and then, may generate the output image by selecting one piece of the image data output respectively from the camera modules 1300a, 1300b, and 1300c. However, one or more embodiments are not limited thereto, and the method of processing the image data may be modified as necessary.

The camera module controller 1414 may provide each of the camera modules 1300a, 1300b, and 1300c with a control signal. The control signals generated by the camera module controller 1414 may be provided to corresponding camera modules 1300a, 1300b, and 1300c via control signal lines CSLa, CSLb, and CSLc separated from one another.

In some embodiments, the control signal provided to the plurality of camera modules 1300a, 1300b, and 1300c from the camera module controller 1414 may include mode information according to the mode signal. The plurality of camera modules 1300a, 1300b, and 1300c may operate in a first operation mode and a second operation mode in relation to the sensing speed, based on the mode information.

In the first operation mode, the plurality of camera modules 1300a, 1300b, and 1300c may generate the image signal at a first speed (for example, generating an image signal of a first frame rate), encodes the image signal at a second speed that is faster than the first speed (for example, encoding the image signal of a second frame rate that is greater than the first frame rate), and transfers the encoded image signal to the application processor 1400. Here, the second speed may be less than or equal to 30 times the first speed.

The application processor 1400 may store the received image signal, that is, the encoded image signal, in the internal memory 1430 provided therein or the external memory 1600 outside the application processor 1400, and after that, reads and decodes the encoded signal from the internal memory 1430 or the external memory1600, and may display the image data generated based on the decoded image signal. For example, the image processors 1411 and 1412 in the image processing device 1410 may perform decoding, and may perform image processing on the decoded image signals.

In the second operation mode, the plurality of camera modules 1300a, 1300b, and 1300c generates an image signal at a third speed that is slower than the first speed (for example, generating the image signal of a third frame rate that is lower than the first frame rate), and may transfer the image signal to the application processor 1400. The image signal provided to the application processor 1400 may be a signal that is not encoded. The application processor 1400 may perform the image processing of the received image signal or store the image signal in the internal memory 1430 or the external memory1600.

The PMIC 1500 may supply the power, for example, the power voltage, to each of the plurality of camera modules 1300a, 1300b, and 1300c. For example, the PMIC 1500 may supply the first power to the camera module 1300a via a power signal line PSLa, the second power to the camera module 1300b via a power signal line PSLb, and the third power to the camera module 1300c via a power signal line PSLc, under the control of the application processor 1400.

The PMIC 1500 may generate the power corresponding to each of the plurality of camera modules 1300a, 1300b, and 1300c and may adjust the power level, in response to a power control signal PCON from the application processor 1400. The power control signal PCON may include a power adjusting signal for each operation mode of the plurality of camera modules 1300a, 1300b, and 1300c. For example, the operation mode may include a low power mode, and the power control signal PCON may include information about the camera module operating in the low-power mode and set power level. The levels of the power provided to the plurality of camera modules 1300a, 1300b, and 1300c may be equal to or different from each other. Also, the power level may be dynamically changed.

According to the embodiment, the nano-photonic lens array may color-separate the incident light without absorbing or reflecting the incident light, and then, condense the color-separated light onto respectively pixels, and accordingly, the light utilization efficiency of the image sensor may be improved. Also, the nano-photonic lens array according to the embodiment may be applied to the image sensor having a pixel arrangement structure, e.g., Bayer pattern, in which the number of certain color channels is two times more than the other color channels in one unit pattern.

Also, according to the embodiment, in the configuration in which one pixel is divided into a plurality of sub-pixels and the sub-pixel is divided into a plurality of photosensitive cells, the AF contrast ratio between the photosensitive cells is increased and the AF function may be improved.

The above-described embodiments are summarized as follows.
(1) An image sensor according to an embodiment includes a sensor substrate including a plurality of unit pixel pattern, each of the plurality of unit pixel pattern including a first pixel, a second pixel, a third pixel, and a fourth pixel, and a nano-photonic lens array on the sensor substrate, the nano-photonic lens array including a plurality of unit meta-patterns, each of the plurality of unit meta-patterns being divided into a first meta-region, a second meta-region, a third meta-region, and a fourth meta-region, wherein the first meta-region, the second meta-region, the third meta-region, and the fourth meta-region include a plurality of main nano-structures, each of the plurality of main nano-structures having a critical dimension greater than or equal to 1/20 of the pixel pitch, wherein the plurality of main nano-structures is configured to form a plurality of light condensing areas in each of the first pixel, the second pixel, the third pixel, and the fourth pixel by condensing light incident on the nano-photonic lens array, wherein a center point of a main nano-structure of the plurality of main nano-structures in the third meta-region that is on an upper side of the third pixel and has the same area as the third pixel is in a third section, and wherein the third section includes a first portion defined along a rim of the third meta-region in the third meta-region, a second portion that extends in a first direction from a center of the third meta-region, and a third portion that extends in a second direction crossing the first direction from the center of the third meta-region.
(2) A width of the first portion, a width of the second portion in the second direction, and a width of the third portion in the first direction may be 1/8 of the pixel pitch.
(3) The second portion and the third portion may cross each other at the center of the third meta-region.
(4) The critical dimension of the main nano-structure may be greater than or equal to 90 nm.
(5) A center point of a main nano-structure of the plurality of main nano-structures in the first meta-region that is on an upper side of the first pixel and has the same area as the first pixel may be in a first section, the first section extending in a first direction from a center of the first meta-region, and a width of the first section in a second direction being 1/4 of a pixel pitch.
(6) A center of the first section may coincide with a center of the first meta-region in the second direction, and a width of the first section in the first direction is equal to a width of the first meta-region in the first direction.
(7) A center point of a main nano-structure of the plurality of main nano-structures in the second meta-region that is on an upper side of the second pixel and has the same area as the second pixel may be in a second section, and the second section may have a square shape having a width in the first direction and a width in the second direction being 1/2 of the pixel pitch.
(8) A center of the second section in the first direction and the second direction coincides with a center of the second meta-region in the first direction and the second direction.
(9) A center point of the main nano-structure of the plurality of main nano-structures in the fourth meta-region that is on an upper side of the fourth pixel and has the same area as the fourth pixel may be in a fourth section, the fourth section extending in the second direction from a center of the fourth meta-region, and a width of the fourth section in the first direction being 1/4 of the pixel pitch.
(10) The fourth section of the fourth meta-region may have a shape rotated by a 90-degree angle with respect to the first section of the first meta-region.
(11) The first section of the first meta-region further may include a portion extending in the second direction from a center of the first meta-region, and a width of the first section, in the first direction, of the portion extending in the second direction may be 1/4 of the pixel pitch.
(12) A center point of the main nano-structure of the plurality of main nano-structures in the fourth meta-region that is on an upper side of the fourth pixel and has the same area as the fourth pixel may be in a fourth section, the fourth section including a portion that extends in the second direction from a center of the fourth meta-region and a portion extending in the first direction from the center of the fourth meta-region, and a width of the fourth section, in the second direction, of the portion extending in the first direction and a width of the fourth section, in the first direction, of the portion extending in the second direction may be 1/4 of the pixel pitch.
(13) Main nano-structures of the plurality of main nano-structures in the first meta-region and the fourth meta-region may be in a 2-fold symmetry, main nano-structures of the plurality of main nano-structures in the second meta-region and the third meta-region may be in a 4-fold symmetry, and an arrangement type of the main nano-structures in the fourth meta-region may be rotated by a 90-degree angle with respect to an arrangement type of the main nano-structures in the first meta-region.
(14) The plurality of main nano-structures may be configured to color-separate incident light that is incident on the nano-photonic lens array and condense light of a first wavelength band onto the first pixel and the fourth pixel, light of a second wavelength band that is less than the first wavelength band onto the second pixel, and light of a third wavelength band that is greater than the first wavelength band onto the third pixel.
(15) The first pixel, the second pixel, the third pixel, and the fourth pixel each may include a first sub-pixel, a second sub-pixel, a third sub-pixel, and a fourth sub-pixel that are grouped and disposed two-dimensionally, and the first sub-pixel, the second sub-pixel, the third sub-pixel, and the fourth sub-pixel may be configured to independently sense the incident light.
(16) The plurality of main nano-structures may be configured to condense the light of the first wavelength band onto a center of the first sub-pixel, a center of the second sub-pixel, a center of the third sub-pixel, and a center of the fourth sub-pixel of the first pixel, and a center of the first sub-pixel, a center of the second sub-pixel, a center of the third sub-pixel, and a center of the fourth sub-pixel of the fourth pixel, condense the light of the second wavelength band onto a center of the first sub-pixel, a center of the second sub-pixel, a center of the third sub-pixel, and a center of the fourth sub-pixel being of the second pixel, and condense the light of the third wavelength band onto a center of the first sub-pixel, a center of the second sub-pixel, a center of the third sub-pixel, and a center of the fourth sub-pixel of the third pixel.
(17) Each of the first sub-pixel, the second sub-pixel, the third sub-pixel, and the fourth sub-pixel may include a plurality of photosensitive cells that are in a group and configured to independently sense the incident light.
(18) The first meta-region, the second meta-region, the third meta-region, and the fourth meta-region further may include a plurality of sub nano-structures each having a critical dimension less than 1/20 of the pixel pitch, and a center point in each of the plurality of sub nano-structures may be included in or outside of the first section.
(19) The nano-photonic lens array may further include a first nano-structure layer and a second nano-structure layer on the first nano-structure layer, the first nano-structure layer and the second nano-structure layer may include the plurality of main nano-structures, and in at least one of the first nano-structure layer and the second nano-structure layer, center points of the plurality of main nano-structures may be in the third section.
(20) An electronic apparatus sensor according to an embodiment includes a lens assembly configured to form an optical image of a subject, an image sensor configured to convert the optical image formed by the lens assembly into an electrical signal, and a processor configured to process a signal generated by the image sensor, wherein the image sensor includes a sensor substrate including a plurality of unit pixel pattern, each of the plurality of unit pixel pattern including a first pixel, a second pixel, a third pixel, and a fourth pixel, and a nano-photonic lens array on the sensor substrate, the nano-photonic lens array including a plurality of unit meta-patterns, each of the plurality of unit meta-patterns being divided into a first meta-region, a second meta-region, a third meta-region, and a fourth meta-region, wherein the first meta-region, the second meta-region, the third meta-region, and the fourth meta-region include a plurality of main nano-structures, each of the plurality of main nano-structures having a critical dimension greater than or equal to 1/20 of the pixel pitch, wherein the plurality of main nano-structures is configured to form a plurality of light condensing areas in each of the first pixel, the second pixel, the third pixel, and the fourth pixel by condensing light incident on the nano-photonic lens array, wherein a center point of a main nano-structure of the plurality of main nano-structures in the third meta-region that is on an upper side of the third pixel and has the same area as the third pixel is in a third section, wherein the third section includes a first portion defined along a rim of the third meta-region in the third meta-region, a second portion that extends in a first direction from a center of the third meta-region, and a third portion that extends in a second direction crossing the first direction from the center of the third meta-region.

It should be understood that embodiments described herein should be considered in a descriptive sense only and not for purposes of limitation. Descriptions of features or aspects within each embodiment should typically be considered as available for other similar features or aspects in other embodiments. While embodiments have been described with reference to the figures, it will be understood by those of ordinary skill in the art that various changes in form and details may be made therein without departing from the scope as defined by the following claims and their equivalents.

## Claims

1. An image sensor comprising:
a sensor substrate comprising a plurality of unit pixel pattern, each of the plurality of unit pixel pattern comprising a first pixel, a second pixel, a third pixel, and a fourth pixel; and
a nano-photonic lens array on the sensor substrate, the nano-photonic lens array comprising a plurality of unit meta-patterns, each of the plurality of unit meta-patterns being divided into a first meta-region, a second meta-region, a third meta-region, and a fourth meta-region,
wherein the first meta-region, the second meta-region, the third meta-region, and the fourth meta-region comprise a plurality of main nano-structures, each of the plurality of main nano-structures having a critical dimension greater than or equal to 1/20 of the pixel pitch,
wherein the plurality of main nano-structures is configured to form a plurality of light condensing areas in each of the first pixel, the second pixel, the third pixel, and the fourth pixel by condensing light incident on the nano-photonic lens array,
wherein a center point of a main nano-structure of the plurality of main nano-structures in the third meta-region that is on an upper side of the third pixel and has the same area as the third pixel is in a third section, and
wherein the third section comprises a first portion defined along a rim of the third meta-region in the third meta-region, a second portion that extends in a first direction from a center of the third meta-region, and a third portion that extends in a second direction crossing the first direction from the center of the third meta-region.

2. The image sensor of claim 1, wherein a width of the first portion, a width of the second portion in the second direction, and a width of the third portion in the first direction are 1/8 of the pixel pitch.

3. The image sensor of claim 1 or 2, wherein the second portion and the third portion cross each other at athe center of the third meta-region.

4. The image sensor of any preceding claim, wherein the critical dimension of the main nano-structure is greater than or equal to 90 nm.

5. The image sensor of any preceding claim, wherein a center point of a main nano-structure of the plurality of main nano-structures in the first meta-region that is on an upper side of the first pixel and has the same area as the first pixel is in a first section, the first section extending in a first direction from a center of the first meta-region, and a width of the first section in a second direction being 1/4 of a pixel pitch.

6. The image sensor of claim 5, wherein a center of the first section coincides with a center of the first meta-region in the second direction, and a width of the first section in the first direction is equal to a width of the first meta-region in the first direction.

7. The image sensor of claim 5 or 6, wherein a center point of a main nano-structure of the plurality of main nano-structures in the second meta-region that is on an upper side of the second pixel and has the same area as the second pixel is in a second section, and the second section has a square shape having a width in the first direction and a width in the second direction being 1/2 of the pixel pitch, and optionally wherein a center of the second section in the first direction and the second direction coincides with a center of the second meta-region in the first direction and the second direction.

8. The image sensor of claim 5 or 6, wherein a center point of the main nano-structure of the plurality of main nano-structures in the fourth meta-region that is on an upper side of the fourth pixel and has the same area as the fourth pixel is in a fourth section, the fourth section extending in the second direction from a center of the fourth meta-region, and a width of the fourth section in the first direction being 1/4 of the pixel pitch, and optionally wherein the fourth section of the fourth meta-region has a shape rotated by a 90-degree angle with respect to the first section of the first meta-region.

9. The image sensor of claim 5 or 6, wherein the first section of the first meta-region further comprises a portion extending in the second direction from a center of the first meta-region, and a width of the first section, in the first direction, of the portion extending in the second direction is 1/4 of the pixel pitch, and optionally wherein a center point of the main nano-structure of the plurality of main nano-structures in the fourth meta-region that is on an upper side of the fourth pixel and has the same area as the fourth pixel is in a fourth section, the fourth section comprising a portion that extends in the second direction from a center of the fourth meta-region and a portion extending in the first direction from the center of the fourth meta-region, and
wherein a width of the fourth section, in the second direction, of the portion extending in the first direction and a width of the fourth section, in the first direction, of the portion extending in the second direction are 1/4 of the pixel pitch.

10. The image sensor of any preceding claim, wherein main nano-structures of the plurality of main nano-structures in the first meta-region and the fourth meta-region are in a 2-fold symmetry,
wherein, main nano-structures of the plurality of main nano-structures in the second meta-region and the third meta-region are in a 4-fold symmetry, and
wherein an arrangement type of the main nano-structures in the fourth meta-region is rotated by a 90-degree angle with respect to an arrangement type of the main nano-structures in the first meta-region.

11. The image sensor of any preceding claim, wherein the plurality of main nano-structures are configured to color-separate incident light that is incident on the nano-photonic lens array and condense light of a first wavelength band onto the first pixel and the fourth pixel, light of a second wavelength band that is less than the first wavelength band onto the second pixel, and light of a third wavelength band that is greater than the first wavelength band onto the third pixel, and optionally wherein the first pixel, the second pixel, the third pixel, and the fourth pixel each comprise a first sub-pixel, a second sub-pixel, a third sub-pixel, and a fourth sub-pixel that are grouped and disposed two-dimensionally, and
wherein the first sub-pixel, the second sub-pixel, the third sub-pixel, and the fourth sub-pixel are configured to independently sense the incident light, and further optionally wherein the plurality of main nano-structures are configured to:
condense the light of the first wavelength band onto a center of the first sub-pixel, a center of the second sub-pixel, a center of the third sub-pixel, and a center of the fourth sub-pixel of the first pixel, and a center of the first sub-pixel, a center of the second sub-pixel, a center of the third sub-pixel, and a center of the fourth sub-pixel of the fourth pixel;
condense the light of the second wavelength band onto a center of the first sub-pixel, a center of the second sub-pixel, a center of the third sub-pixel, and a center of the fourth sub-pixel of the second pixel; and
condense the light of the third wavelength band onto a center of the first sub-pixel, a center of the second sub-pixel, a center of the third sub-pixel, and a center of the fourth sub-pixel of the third pixel.

12. The image sensor of claim 11, wherein each of the first sub-pixel, the second sub-pixel, the third sub-pixel, and the fourth sub-pixel comprises a plurality of photosensitive cells that are in a group and configured to independently sense the incident light.

13. The image sensor of any preceding claim, wherein the first meta-region, the second meta-region, the third meta-region, and the fourth meta-region further comprise a plurality of sub nano-structures each having a critical dimension less than 1/20 of the pixel pitch, and
wherein a center point in each of the plurality of sub nano-structures is included in or outside of the first section.

14. The image sensor of any preceding claim, wherein the nano-photonic lens array further comprises a first nano-structure layer and a second nano-structure layer on the first nano-structure layer,
wherein the first nano-structure layer and the second nano-structure layer comprise the plurality of main nano-structures, and
wherein, in at least one of the first nano-structure layer and the second nano-structure layer, center points of the plurality of main nano-structures are in the third section.

15. An electronic apparatus comprising:
a lens assembly configured to form an optical image of a subject;
an image sensor according to any preceding claim configured to convert the optical image formed by the lens assembly into an electrical signal; and
a processor configured to process a signal generated by the image sensor.
